# EUROPEAN PATENT SPECIFICATION

(11) **EP 4 213 604 B1**
(45) Date of publication and mention of the grant of the patent: **22.01.2025**
(21) Application number: 22831231.0
(22) Date of filing: 09.03.2022
(51) Int. Cl.: H10K 59/131, H10K 59/121, G09G 3/3233, H01L 27/12

(54) **DISPLAY SUBSTRATE, MANUFACTORING METHOD THEREFOR, AND DISPLAY DEVICE THEREWITH**
ANZEIGESUBSTRAT, HERSTELLUNGSVERFAHREN DAFÜR UND ANZEIGEVORRICHTUNG DAMIT
SUBSTRAT D'AFFICHAGE, SON PROCÉDÉ DE FABRICATION ET APPAREIL D'AFFICHAGE AVEC CECI

(30) Priority: 30.06.2021 CN 202121504315 U; 17.08.2021 CN 202110944835
(43) Date of publication of application: 19.07.2023
(73) Proprietor: BOE Technology Group Co., Ltd., Beijing 100015 (CN); Hefei Boe Joint Technology Co., Ltd., Xinzhan District Hefei Anhui 230012 (CN)
(72) Inventor: YUAN, Can, Beijing 100176 (CN); LI, Yongqian, Beijing 100176 (CN)
(74) Representative: Durán-Corretjer, S.L.P.
(86) International application number: PCT/CN2022/079975
(87) International publication number: WO 2023/273400

(56) References cited:
- CN-A- 108 598 139
- CN-A- 109 637 374
- CN-A- 111 326 563
- CN-A- 111 863 916
- CN-A- 112 331 714
- US-A1- 2011 267 572
- US-A1- 2019 035 874
- US-A1- 2020 410 921

## Description

### Technical Field

The present application relates to a display substrate, a method for manufacturing the display substrate, and a display device.

### Background

An Organic Light Emitting Diode (OLED) is an active light emitting display device, which has advantages such as self-luminescence, ultra-thinness, wide angle of view, high brightness, high contrast, relatively low power consumption, very high response speed, etc. Depending upon driving modes, OLEDs may be divided into two types, i.e., a passive matrix (PM) type and an active matrix (AM) type. An AMOLED is a current driven device in which an independent thin film transistor (TFT) is used for controlling each sub-pixel, and each sub-pixel may be continuously and independently driven to emit light.

With the continuous development of display technology, the OLED technology is increasingly applied in transparent display. Transparent display is an important personalized display field of the display technology, which refers to implement image display in a transparent state, in which a viewer can see not only images in a display device, but also scenes behind the display device, and Virtual Reality (VR) and Augmented Reality (AR) and 3D display functions can be implemented. In a transparent display device using the AMOLED technology, each pixel is generally divided into a display area and a transparent area. The display area is provided with pixel drive circuits and light emitting elements to implement image display, and the transparent area can allow light to transmit therethrough. Related technologies include CN112331714A, CN111863916A and US2020/410921A1.

CN112331714A discloses a display substrate and a display device. The display substrate comprises a first conductive structure, the first conductive structure comprises a first surface, a third surface, a second surface and a fourth surface, the first surface and the third surface are opposite, the second surface and the fourth surface are opposite, the first surface and the second surface are made of the same material, and the first surface and the second surface form different included angles with the surface of a substrate body; a first surface microstructure is arranged on the first surface, and a second surface microstructure is arranged on the second surface; the first surface microstructure has a first cross section perpendicular to the substrate, and the first cross section has a first orthographic projection on the third surface; the length of the first orthographic projection is smaller than the length of the first surface microstructure on the first section; the second surface microstructure has a second cross section perpendicular to the substrate base plate, the second cross section has a second orthographic projection on the fourth surface, and the length of the second orthographic projection is smaller than the length of the second surface microstructure on the second cross section. The display substrate can effectively improve the yield.,

CN111863916A discloses an electrostatic protection circuit, a display substrate, and a display device. The electrostatic protection circuit includes: a plurality of first transistors provided on a substrate, the first transistors including gates, an active layer, a first pole, a second pole, and a connection portion; the gates of the plurality of first transistors are connected to each other to form a control line; a first electrode of the first transistor is electrically connected with the crack detection line, the connecting part is connected between the first electrode and the second electrode, and an active layer and a grid electrode of the first transistor are overlapped and spaced in an insulated manner to form a first capacitor; the control line is electrically connected with the first power line; a first via hole is formed in the insulating layer between the layer where the first power line is located and the layer where the control line is located; the first power line is electrically connected with the control line through the first via hole, a first distance exists between the orthographic projection of the first capacitor close to the first via hole on the substrate and the orthographic projection of the first via hole on the substrate, and the ratio of the first distance to the size of the first capacitor in the direction perpendicular to the connecting part is larger than 0.375.

US2020/410921A1 provides a display device which includes a substrate including a first display area and a second display area; a signal line which overlaps the first display area and the second display area; and a common electrode which overlaps the first display area and the second display area, where the first display area includes a first pixel area, the second display area includes a second pixel area and a transmitting area, the transmitting area includes a first transmitting area and a second transmitting area, which have different transmittances from each other, the common electrode overlaps the first pixel area, the second pixel area and the second transmitting area, and in the second transmitting area, at least a part of the signal line and the common electrode overlap each other.

### Summary

The present invention is defined in the appended claims.

The present disclosure provides a display substrate, including a base substrate and multiple display units disposed on the base substrate, wherein each display unit includes a display area and a transparent area. The display area includes multiple sub-pixels. The display area is provided with a first power supply line and a second power supply line along a first direction. The first power supply line and the second power supply line extend along a second direction. The display area is provided with a first scan signal line, a second scan signal line, a second scan connection line and a first scan connection line along the second direction. The second scan connection line and the second scan signal line are connected to each other to form a first annular structure. The display area is provided with a third scan connection line between the first scan signal line and the first scan connection line. The third scan connection line, the first scan connection line and the first scan signal line are connected to each other to form a second annular structure. The first direction intersects with the second direction. An orthographic projection of the first annular structure on the base substrate is not overlapped an orthographic projection of the first power supply line and the second power supply line on the base substrate. An orthographic projection of the second annular structure on the base substrate is not overlapped with orthographic projection of the first power supply line and the second power supply line on the base substrate.

Furthermore, the orthographic projection of the first annular structure on the base substrate is not overlapped with the orthographic projection of the second annular structure on the base substrate, and the orthographic projection of the second annular structure on the base substrate wraps the orthographic projection of the first annular structure on the base substrate.

In an exemplary implementation, in a direction perpendicular to the display substrate, a sub-pixel includes a drive circuit layer disposed on the base substrate and a light emitting structure layer disposed at a side of the drive circuit layer away from the base substrate. The drive circuit layer includes a first conductive layer, a semiconductor layer, a second conductive layer, and a third conductive layer. The first conductive layer includes a compensation signal line and a first plate. The semiconductor layer includes active layers of multiple transistors. The second conductive layer includes the first scan signal line, the second scan signal line, the first scan connection line, the second scan connection line, a second plate and gates of multiple transistors. The third conductive layer includes the first power supply line, the second power supply line, the third scan connection line, data signal lines, and sources and drains of the multiple transistors. There is an overlapped area between an orthographic projection of the second plate on the base substrate and an orthographic projection of the first plate on the base substrate, so that a first capacitance is formed. The second scan connection line and the second scan signal line are connected to each other to form an integrated structure. The third scan connection line is electrically connected to the first scan connection line and the first scan signal line through vias respectively.

In an exemplary implementation, at least one of the sub-pixel includes a first transistor, a second transistor, a third transistor and a first capacitor. The first capacitor includes a first plate and a second plate. A gate of the first transistor is electrically connected to the first scan signal line, a first electrode of the first transistor is electrically connected to the data signal line, a second electrode of the first transistor is electrically connected to a gate of the second transistor, a first electrode of the second transistor is electrically connected to the first power supply line, a second electrode of the second transistor is electrically connected to a first electrode of an organic light emitting diode, a gate of the third transistor is electrically connected to the second scan signal line, a first electrode of the third transistor is electrically connected to the compensation signal line, a second electrode of the third transistor is electrically connected to the second electrode of the second transistor, a second electrode of the organic light emitting diode is electrically connected to the second power supply line, the first plate is electrically connected to the second electrode of the second transistor, and the second plate is electrically connected to the gate of the second transistor.

In an exemplary implementation, the multiple sub-pixels include a first sub-pixel, a second sub-pixel, a third sub-pixel, and a fourth sub-pixel. In the first direction, the first sub-pixel and the second sub-pixel are alternately arranged to form a first row, the third sub-pixel and the fourth sub-pixel are alternately arranged to form a second row. In the second direction, the first sub-pixel and the third sub-pixel are alternately arranged to form a first column, and the second sub-pixel and the fourth sub-pixel are alternately arranged to form a second column. The first scan connection line and the second scan connection line are located in the first sub-pixel and the second sub-pixel respectively, and the first scan signal line and the second scan signal line are located in the third sub-pixel and the fourth sub-pixel respectively.

In an exemplary implementation, at least one of the sub-pixels includes a first transistor, a second transistor and a third transistor. The first transistor includes a first active layer, a first gate, a first source, and a first drain. The second transistor includes a second active layer, a second gate, a second source, and a second drain. The third transistor includes a third active layer, a third gate, a third source, and a third drain. An area where the second scan signal line is overlapped with the third active layers in the third sub-pixel and the fourth sub-pixel serves as third gates in the third sub-pixel and the fourth sub-pixel. An area where the second scan connection line is overlapped with the third active layers in the first sub-pixel and the second sub-pixel serves as third gates in the first sub-pixel and the second sub-pixel. An area where the first scan signal line is overlapped with the first active layers in the third sub-pixel and the fourth sub-pixel serves as first gates in the third sub-pixel and the fourth sub-pixel. An area where the first scan connection line is overlapped with the first active layers in the first sub-pixel and the second sub-pixel serves as first gates in the first sub-pixel and the second sub-pixel.

In an exemplary implementation, at least one of the display areas further includes a compensation signal line extending in the second direction. The first gates, the second gates and the third gates in the first sub-pixel and the second sub-pixel are mirror-symmetrical with respect to a vertical axis. The first gates, the second gates and the third gates in the first sub-pixel and the second sub-pixel are mirror-symmetrical with respect to the vertical axis. The vertical axis is the compensation signal line.

In an exemplary implementation, the compensation signal line is provided with compensation connection lines that protrude in the first direction and in an opposite direction of the first direction. The compensation connection line is located at an abutment position of the first sub-pixel and the third sub-pixel and an abutment position of the second sub-pixel and the fourth sub-pixel. The compensation connection line is electrically connected to the third source of the third transistor through a via.

In an exemplary implementation, the third active layers in the first sub-pixel to the fourth sub-pixel are each disposed at a position close to the compensation connection line, and there is an overlapped area between an orthographic projection of the third active layers on the base substrate and an orthographic projection of the compensation connection line on the base substrate.

In an exemplary implementation, the third active layer in the first sub-pixel and the third active layer in the third sub-pixel are connected to each other to form an integrated structure, and the third active layer in the second sub-pixel and the third active layer in the fourth sub-pixel are connected to each other to form an integrated structure.

In an exemplary implementation, at least one of the sub-pixels further includes a first capacitor. The first capacitor includes a first plate and a second plate disposed oppositely. The second gate is disposed across the second active layer and connected to the second plate to form an integrated structure.

In an exemplary implementation, the first plate in the first sub-pixel is provided with a first opening at a side close to the third sub-pixel and away from the second sub-pixel. The first plate in the second sub-pixel is further provided with the first opening at a side close to the fourth sub-pixel and away from the first sub-pixel. The first plate in the third sub-pixel is provided with a second opening at a side close to the first sub-pixel and close to the fourth sub-pixel. The first plate in the fourth sub-pixel is further provided with the second opening at a side close to the second sub-pixel and close to the third sub-pixel. The first active layer in the first sub-pixel and the second sub-pixel is disposed at a position close to the first opening, and the first active layer in the third and fourth sub-pixels is disposed at a position close to the second opening.

In an exemplary implementation, at least one of the sub-pixels further includes a second capacitor, the second capacitor includes a second plate and a third plate oppositely disposed. There is an overlapped area between an orthographic projection of the third plate on the base substrate and an orthographic projection of the second plate on the base substrate, and the third plate is electrically connected to the first plate through a via.

An embodiment of the present disclosure further provides a display device, which includes the display substrate as described above.

An embodiment of the present disclosure further provides a method for manufacturing a display substrate in accordance with claim 14.

Other aspects may be comprehended upon reading and understanding of the drawings and detailed descriptions.

### Brief Description of Drawings

Accompanying drawings are used for providing understanding of technical solutions of the present disclosure, and form a part of the specification. They are used for explaining the technical solutions of the present disclosure together with embodiments of the present disclosure, but do not form a limitation on the technical solutions of the present disclosure.
FIG. 1 is a schematic diagram of a structure of a display device.
FIG. 2 is a schematic diagram of a planar structure of a display substrate.
FIG. 3 is a schematic diagram of a sectional structure of a display substrate.
FIG. 4 is a schematic equivalent circuit diagram of a pixel drive circuit.
FIG. 5 is a schematic diagram of a structure of a display panel according to an exemplary embodiment of the present disclosure.
FIG. 6 is a schematic equivalent circuit diagram of pixel drive circuits in four sub-pixels shown in FIG. 5.
FIG. 7 is a schematic diagram after a pattern of a first conductive layer is formed according to an exemplary embodiment of the present disclosure.
FIG. 8 is a schematic diagram of a sectional structure of a region AA in FIG. 7.
FIG. 9 is a schematic diagram after a pattern of a semiconductor layer is formed according to an exemplary embodiment of the present disclosure.
FIG. 10 is a schematic diagram of a sectional structure of a region AA in FIG. 9.
FIG. 11 is a schematic diagram after a pattern of a second conductive layer is formed according to an exemplary embodiment of the present disclosure.
FIG. 12 is a schematic diagram of a sectional structure of a region AA in FIG. 11.
FIG. 13 is a schematic diagram after a pattern of a third insulation layer is formed according to an exemplary embodiment of the present disclosure.
FIG. 14 is a schematic diagram of a sectional structure of a region AA in FIG. 13.
FIG. 15 is a schematic diagram after a pattern of a third conductive layer is formed according to an exemplary embodiment of the present disclosure.
FIG. 16 is a schematic diagram of a sectional structure of a region AA in FIG. 15.
FIG. 17 is a schematic diagram after a pattern of a planarization layer is formed according to an exemplary embodiment of the present disclosure.
FIG. 18 is a schematic diagram of a sectional structure of a region AA in FIG. 17.
FIG. 19 is a schematic diagram after a pattern of a first transparent conductive layer is formed according to an exemplary embodiment of the present disclosure.
FIG. 20 is a schematic diagram of a sectional structure of a region AA in FIG. 19.
FIG. 21 is a schematic diagram after a pattern of an anode is formed according to an exemplary embodiment of the present disclosure.
FIG. 22 is a schematic diagram of a sectional structure of a region AA in FIG. 21.
FIG. 23 is a schematic diagram after a pattern of a first pixel definition layer is formed according to an exemplary embodiment of the present disclosure.
FIG. 24 is a schematic diagram of a sectional structure of a region AA in FIG. 23.
FIG. 25 is a schematic diagram after a pattern of an organic emitting layer is formed according to an exemplary embodiment of the present disclosure.
FIG. 26 is a schematic diagram after a pattern of a cathode is formed according to an exemplary embodiment of the present disclosure.
FIG. 27 is a schematic diagram of a short circuit fault point and a laser repair method of a display substrate according to an exemplary embodiment of the present disclosure.
FIG. 28 is another schematic diagram of a short circuit fault point and a laser repair method of display substrate according to an exemplary embodiment of the present disclosure.

### Detailed Description

To make objectives, technical solutions, and advantages of the present disclosure clearer, the embodiments of the present disclosure will be described in detail with reference to the accompanying drawings. Implementations may be implemented in multiple different forms.

Scales of the drawings in the present disclosure may be used as a reference in an actual process, but are not limited thereto. For example, a width-length ratio of a channel, a thickness and spacing of each film layer, and a width and spacing of each signal line may be adjusted according to actual needs. The number of pixels in a display substrate and the number of sub-pixels in each pixel are not limited to numbers shown in the drawings. The drawings described in the present disclosure are schematic structural diagrams only, and one implementation of the present disclosure is not limited to the shapes, numerical values or the like shown in the drawings.

Ordinal numerals such as "first", "second", and "third" in the specification are set to avoid confusion between constituent elements, but not to set a limit in quantity.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred device or element must have a particular orientation and be constructed and operated in the particular orientation. Therefore, they cannot be understood as limitations on the present disclosure. The positional relationships between the constituent elements may be changed as appropriate according to directions for describing the various constituent elements. Therefore, appropriate replacements may be made according to situations without being limited to the wordings described in the specification.

In the specification, unless otherwise specified and defined explicitly, terms "mount", "mutually connect", and "connect" should be understood in a broad sense. A connection may be a fixed connection, a detachable connection, or an integral connection. It may be a mechanical connection or an electrical connection. It may be a direct mutual connection, or an indirect connection through middleware, or internal communication between two components. Those of ordinary skills in the art may understand specific meanings of these terms in the present disclosure according to specific situations.

In the specification, a transistor refers to an element which includes at least three terminals, i.e., a gate, a drain and a source. The transistor has a channel region between the drain (drain terminal, drain region, or drain electrode) and the source (source terminal, source region, or source electrode), and a current can flow through the drain, the channel region, and the source. It is to be noted that, in the specification, the channel region refers to a region through which the current mainly flows.

In the specification, a first electrode may be a drain, and a second electrode may be a source. Or, the first electrode may be the source, and the second electrode may be the drain. In cases that transistors with opposite polarities are used, a current direction changes during operation of a circuit, or the like, functions of the "source" and the "drain" are sometimes interchangeable. Therefore, the "source" and the "drain", as well as the "source terminal" and the "drain terminal" are interchangeable in the specification.

In the specification, "electrical connection" includes a case that constituent elements are connected together through an element with a certain electrical effect. The "element with the certain electrical effect" is not particularly limited as long as electrical signals may be sent and received between the connected constituent elements. Examples of the "element with the certain electrical effect" not only include electrodes and wirings, but also include switch elements such as transistors, resistors, inductors, capacitors, other elements with various functions, etc.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

Triangle, rectangle, trapezoid, pentagon and hexagon in this specification are not strictly defined, and they may be approximate triangle, rectangle, trapezoid, pentagon or hexagon, etc. There may be some small deformation caused by tolerance, and there may be chamfer, arc edge and deformation, etc.

In the present disclosure, "about" refers to that a boundary is defined not so strictly and numerical values within process and measurement error ranges are allowed.

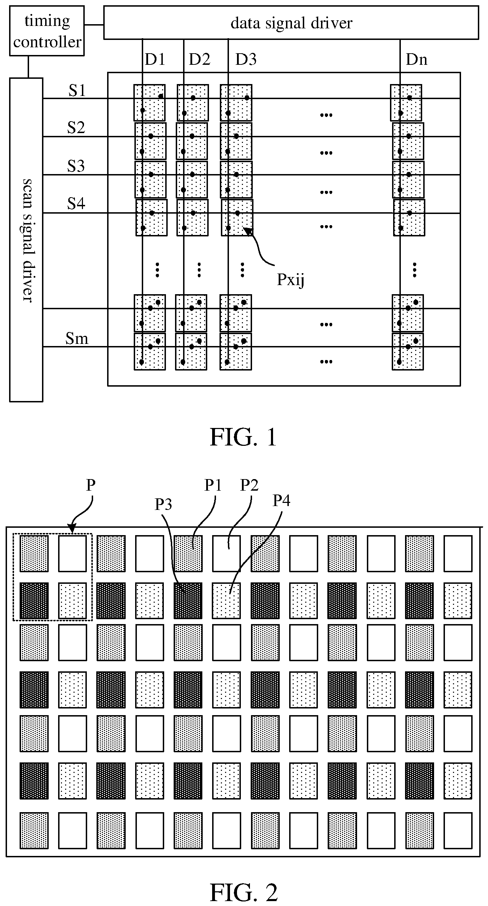

FIG. 1 is a schematic diagram of a structure of a display device. As shown in FIG. 1, the display device may include a timing controller, a data signal driver, a scan signal driver, and a pixel array. The timing controller is connected to the data signal driver and the scan signal driver respectively, the data signal driver is connected to multiple data signal lines (D1 to Dn) respectively, and the scan signal driver is connected to multiple scan signal lines (S1 to Sm) respectively. The pixel array may include multiple sub-pixels Pxij, wherein i and j may be natural numbers. At least one sub-pixel Pxij may include a circuit unit and a light emitting device connected to the circuit unit, wherein the circuit unit may include at least one scan signal line, at least one data signal line and a pixel drive circuit. In an exemplary implementation, the timing controller may provide the data signal driver with a gray scale value and a control signal suitable for the specification of the data signal driver, and may provide the scan signal driver with a clock signal, a scan start signal, and the like suitable for the specification of the scan signal driver. The data signal driver may generate a data voltage to be provided to the data signal lines D1, D2, D3, ..., and Dn by using the gray scale value and the control signal that are received from the timing controller. For example, the data signal driver may sample the gray scale value using a clock signal and apply a data voltage corresponding to the gray scale value to the data signal lines D1 to Dn by taking a pixel row as a unit, wherein n may be a natural number. The scan signal driver may receive the clock signal, the scan start signal, etc., from the timing controller to generate a scan signal to be provided to the scan signal lines S1, S2, S3, ..., and Sm. For example, the scan signal driver may sequentially provide a scan signal with an on-level pulse to the scan signal lines S1 to Sm. For example, the scan signal driver may be constructed in a form of a shift register and generate a scan signal by sequentially transmitting a scan start signal provided in a form of an on-level pulse to a next-stage circuit under control of the clock signal, wherein m may be a natural number.

FIG. 2 is a schematic diagram of a planar structure of a display substrate. As shown in FIG. 2, the display substrate may include multiple pixel units P arranged in a matrix manner. At least one of the multiple pixel units P includes a first sub-pixel P1 emitting a first color light, a second sub-pixel P2 emitting a second color light, a third sub-pixel P3 emitting a third color light and a fourth sub-pixel P4 emitting a fourth color light. The four sub-pixels may each include a circuit unit and a light emitting device. The circuit unit may include a scan signal line, a data signal line and a pixel drive circuit. The pixel drive circuit is respectively connected to the scan signal line and the data signal line. The pixel drive circuit is configured to receive the data voltage transmitted by the data signal line and output a corresponding current to the light emitting device under the control of the scan signal line. The light emitting device in each sub-pixel is connected to a pixel drive circuit of a sub-pixel where the light emitting device is located, and is configured to emit light with a corresponding brightness in response to a current output by the pixel drive circuit of the sub-pixel where the light emitting device is located.

In an exemplary implementation, the first sub-pixel P1 may be a red sub-pixel (R) emitting red light, the second sub-pixel P2 may be a green sub-pixel (G) emitting green light, the third sub-pixel P3 may be a white sub-pixel (W) emitting white light, and the fourth sub-pixel P4 may be a blue sub-pixel (B) emitting blue light.

In an exemplary implementation, a sub-pixel may be a rectangle, a rhombus, a pentagon, or a hexagon. In an exemplary implementation, the four sub-pixels may be arranged in a horizontal side-by-side manner to form an RWBG pixel arrangement. In another exemplary implementation, the four sub-pixels may be arranged in a square, diamond, vertical side-by-side manner or the like, which is not limited here in the present disclosure.

In an exemplary implementation, multiple sub-pixels sequentially arranged in the horizontal direction are referred to as a pixel row, and multiple sub-pixels sequentially arranged in the vertical direction are referred to as a pixel column. Multiple pixel rows and multiple pixel columns together form a pixel array.

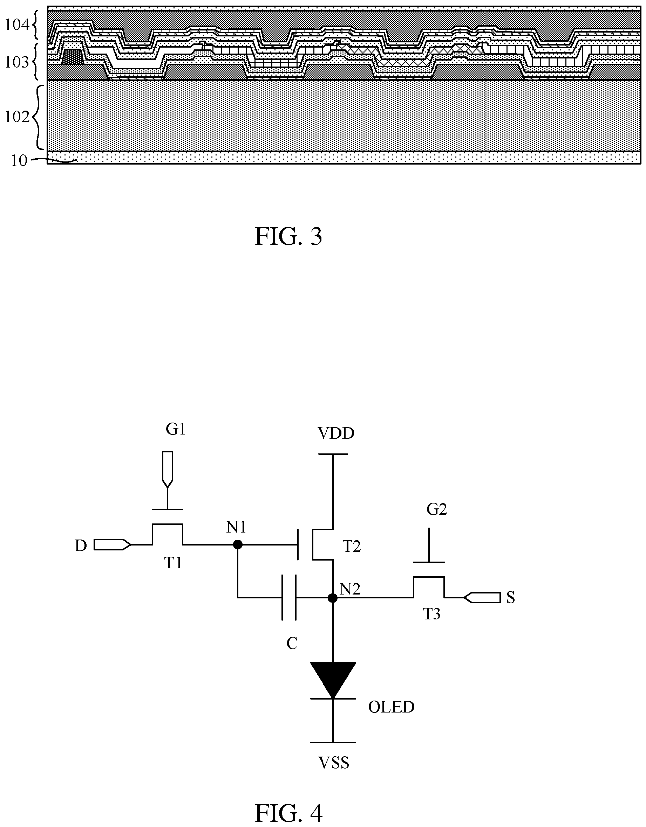

FIG. 3 is a schematic diagram of a sectional structure of a display substrate, and illustrates a structure of four sub-pixels of the display substrate. As shown in FIG. 3, on a plane perpendicular to the display substrate, each sub-pixel of the display substrate may include a drive circuit layer 102 disposed on a base substrate 10, a light emitting structure layer 103 disposed at a side of the drive circuit layer 102 away from the base substrate, and an encapsulation layer 104 disposed at a side of the light emitting structure layer 103 away from the base substrate.

In an exemplary implementation, the base substrate 10 may be a flexible base substrate, or a rigid base substrate. The drive circuit layer 102 of each sub-pixel may include a pixel drive circuit formed by multiple transistors and a storage capacitor. The light emitting structure layer 103 of each sub-pixel may include a light emitting device formed by multiple film layers. The multiple film layers may include an anode, a pixel definition layer, an organic light emitting layer, and a cathode. The anode is connected to a pixel drive circuit. The organic light emitting layer is connected to the anode. The cathode is connected to the organic light emitting layer. The organic light emitting layer emits light of a corresponding color under driving by the anode and the cathode. The encapsulation layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer to ensure that external water vapor cannot enter the light emitting structure layer 103.

In an exemplary implementation, the organic light emitting layer may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL). In an exemplary implementation, the hole injection layer, the hole transport layer, the electron block layer, the hole block layer, the electron transport layer and the electron injection layer of all sub-pixels may be connected together to form a common layer, and the emitting layers of all sub-pixels may be connected together to form a common layer, or may be isolated from each other, and the emitting layers of adjacent sub-pixels may overlap slightly. In some possible implementations, the display substrate may include other film layers, which are not limited here in the present disclosure.

In an exemplary implementation, the pixel drive circuit may have a structure of 3T1C, 4T1C, 5T1C, 5T2C, 6T1C, 7T1C or 8T1C. FIG. 4 is a schematic diagram of an equivalent circuit of a pixel drive circuit. As shown in FIG. 4, the pixel drive circuit has a structure of 3T1C, which may include three transistors (a first transistor T1, a second transistor T2, and a third transistor T3), one storage capacitor C, and six signal lines (a data signal line D, a first scan signal line G1, a second scan signal line G2, a compensation signal line S, a first power supply line VDD, and a second power supply line VSS).

In an exemplary implementation, the first transistor T1 is a switch transistor, the second transistor T2 is a drive transistor, and the third transistor T3 is a compensation transistor. A first electrode of the storage capacitor C is coupled to a control electrode of the second transistor T2, a second electrode of the storage capacitor C is coupled to a second electrode of the second transistor T2, and the storage capacitor C is configured to store a potential of the control electrode of the second transistor T2. A control electrode of the first transistor T1 is coupled to the first scan signal line G1, a first electrode of the first transistor T1 is coupled to the data signal line D, a second electrode of the first transistor T1 is coupled to the control electrode of the second transistor T2. The first transistor T1 is configured to receive a data signal transmitted by the data signal line D under control of the first scan signal line G1, so that the control electrode of the second transistor T2 receives the data signal. The control electrode of the second transistor T2 is coupled to a second electrode of the first transistor T1, a first electrode of the second transistor T2 is coupled to the first power supply line VDD, the second electrode of the second transistor T2 is coupled to a first electrode of a light emitting device, and the second transistor T2 is configured to generate a corresponding current at its second electrode under control of the data signal received by the control electrode of the second transistor. A control electrode of the third transistor T3 is coupled to the second scan signal line G2, a first electrode of the third transistor T3 is coupled to the compensation signal line S, a second electrode of the third transistor T3 is coupled to the second electrode of the second transistor T2. The third transistor T3 is configured to extract a threshold voltage Vth and a mobility of the second transistor T2 in response to compensation timing to compensate the threshold voltage Vth.

In an exemplary implementation, the light emitting device may be an OLED, including a first electrode (anode), an organic emitting layer, and a second electrode (cathode) which are stacked. The first electrode of the OLED is coupled to the second electrode of the second transistor T2, a second electrode of the OLED is coupled to the second power supply line VSS, and the OLED is configured to emit light with corresponding brightness in response to the current of the second electrode of the second transistor T2.

In an exemplary implementation, a signal of the first power supply line VDD is a high-level signal continuously provided, and a signal of the second power supply line VSS is a low-level signal. The first transistor T1 to the third transistor T3 may be P-type transistors or may be N-type transistors. Use of a same type of transistors in a pixel drive circuit may simplify a process flow, reduce process difficulties of a display panel, and improve a product yield.

In an exemplary implementation, for the first transistor T1 to the third transistors T3, low temperature poly silicon thin film transistors may be used, oxide thin film transistors may be used, or low temperature poly silicon thin film transistors and oxide thin film transistors may be used. An active layer of a low temperature poly silicon thin film transistor is made of Low Temperature Poly Silicon (LTPS for short), and an active layer of an oxide thin film transistor is made of an oxide. The low temperature poly silicon thin film transistor has advantages of a high mobility, fast charging, and the like, and the oxide thin film transistor has advantages of a low leakage current and the like. In an exemplary implementation, a low temperature poly silicon thin film transistor and an oxide thin film transistor may be integrated on one display substrate to form a Low Temperature Polycrystalline Oxide (LTPO for short) display substrate, so that advantages of the two types of thin film transistors may be utilized, high Pixel Per Inch (PPI for short) and low-frequency drive may be achieved, power consumption may be reduced, and display quality may be improved. In an exemplary implementation, the light emitting device may be an organic light emitting diode (OLED), including a first electrode (anode), an organic light emitting layer, and a second electrode (cathode) that are stacked.

In an exemplary implementation, taking that all three transistors are N-type transistors as an example, an operation process of the pixel drive circuit illustrated in FIG. 4 may include:
In a first stage A1, signals of the first scan signal line G1 and the second scan signal line G2 are high level signals, the data signal line D outputs a data voltage, the compensation signal line S outputs a compensation voltage, a signal of the first power supply line VDD is at a high level, and a signal of the second power supply line VSS is at a low level. The signal of the first scan signal line G1 is a high level signal, so that the first transistor T1 is turned on, the data voltage output by the data signal line D is written into the first node N1, a potential of the first node N1 is pulled up, and the storage capacitor C is charged. At this time, the potential of the first node N1 is V₁=V_{data}. The signal of the second scan signal line G2 is a high level signal, so that the third transistor T3 is turned on, and the compensation voltage output by the compensation signal line S is written to the second node N2. At this time, a potential the potential of the second node N2 is V₂=Vₛ. Since a potential difference between the first node N1 and the second node N2 is greater than a threshold voltage Vₜₕ of the second transistor T2, the second transistor T2 is turned on. A power supply voltage output from the first power supply line VDD provides a driving voltage to the first electrode of the OLED through the turned-on second transistor T2 to drive the OLED to emit light.

In a second stage A2, the signals of the first scan signal line G1 and the second scan signal line G2 are low level signals, so that the first transistor T1 and the third transistor T3 are turned off, the voltage in the storage capacitor C still keeps the second transistor T2 in a turned-on state, the power supply voltage output by the first power supply line VDD continuously pulls up the potential of the second node N2, and the OLED continuously emits light. When the potential of the second node N2 is equal to V_{data}-Vₜₕ, the second transistor T2 is turned off and the OLED no longer emits light.

In an exemplary implementation, to drive the OLED to emit light normally, the OLED and the second transistor T2 are both forward biased. In the first stage, the power supply voltage output by the first power supply line VDD is greater than the data voltage output by the data signal line D, the data voltage output by the data signal line D is greater than the compensation voltage output by the compensation signal line S, and the compensation voltage output by the compensation signal line S is greater than a power supply voltage output by the second power supply line VSS.

With the continuous development of display technology, the OLED technology is increasingly applied in transparent display. Transparent display is an important personalized display field of the display technology, which refers to implement image display in a transparent state, in which a viewer can see not only images in a display device, but also scenes behind the display device, and Virtual Reality (VR) and Augmented Reality (AR) and 3D display functions can be implemented. In a transparent display device using the AMOLED technology, each pixel is generally divided into a display area and a transparent area. The display area is provided with pixel drive circuits and light emitting elements for implementing image display, and the transparent area implements light transmission.

However, in large-size transparent display products, an overlapped area between a power supply line and other signal lines is relatively large, which easily affects the product yield and leads to that the product's reliability cannot meet the process requirements.

An exemplary embodiment of the present disclosure provides a display substrate including a base substrate and multiple display units disposed on the base substrate. At least one display unit includes a display area and a transparent area, and at least one display area includes multiple sub-pixels.

At least one display area is provided with a first power supply line and a second power supply line along a first direction. The first power supply line and the second power supply line extend in a second direction. At least one display area is provided with a first scan signal line, a second scan signal line, a second scan connection line and a first scan connection line in the second direction. The second scan connection line and the second scan signal line are connected to each other to form a first annular structure. The at least one display area is provided with a third scan connection line between the first scan signal line and the first scan connection line. The third scan connection line, the first scan connection line and the first scan signal line are connected to each other to form a second annular structure, and the first direction intersects with the second direction.

There is no overlapped area between an orthographic projection of the first annular structure on the base substrate and an orthographic projection of the first power supply line and the second power supply line on the base substrate. There is no overlapped area between an orthographic projection of the second annular structure on the base substrate and the orthographic projection of the first power supply line and the second power supply line on the base substrate.

In the display substrate according to the embodiment of the present disclosure, the first scan signal line and the second scan signal line are respectively annularly wound with the corresponding scan connection lines in the display area, and the annular wound positions of the first scan signal line and the second scan signal line keep away from the first power supply line and the second power supply line. Therefore, a problem that a relatively large overlapped area between power supply lines and other signal lines leads to impact on the product yield is avoided. Under a functional condition where maintenance is available, the cross points between signal lines can be optimized to the minimum, thereby improving the product yield and providing technical support for transparent display products.

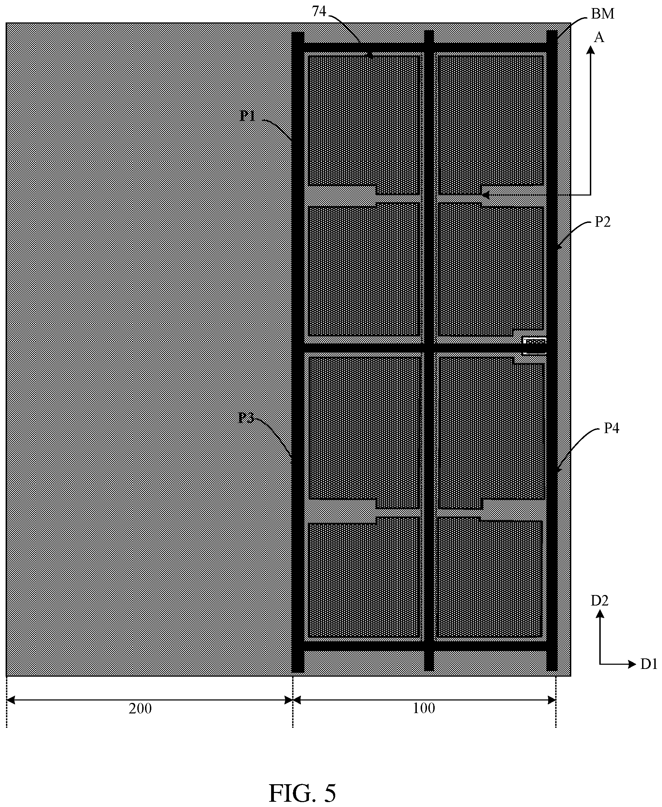

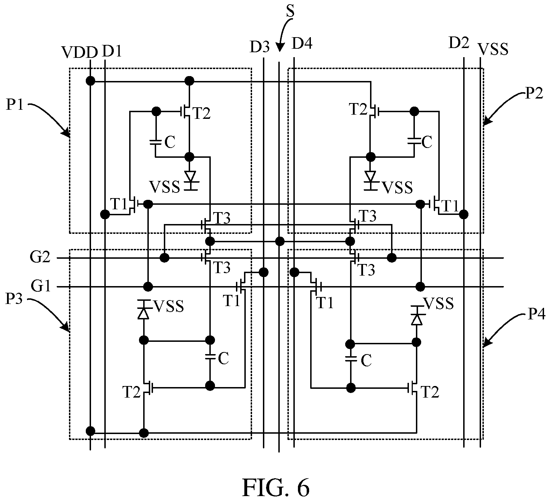

FIG. 5 is a schematic diagram of a structure of a display panel according to an exemplary embodiment of the present disclosure, illustrating a structure of four sub-pixels (one pixel unit), and FIG. 6 is a schematic equivalent circuit diagram of the pixel drive circuits in the four sub-pixels shown in FIG. 5. As shown in FIGS. 5 and 6, in a direction parallel to the display substrate, at least one pixel unit may include a first sub-pixel P1, a second sub-pixel P2, a third sub-pixel P3, and a fourth sub-pixel P4 arranged in sequence, and each sub-pixel includes a pixel drive circuit and a storage capacitor. In the following description, the sub-pixels refer to regions in which the pixel drive circuits are provided. In an exemplary implementation, at least one pixel unit may further include one first scan signal line G1, one second scan signal line G2, one first power supply line VDD, one second power supply line VSS, four data signal lines D (in FIG. 6, the four data signal lines D are a first data signal line D1 to a fourth data signal line D4, the first sub-pixel P1 is connected to the first data signal line D1, the second sub-pixel P2 is connected to the second data signal line D2, the third sub-pixel P3 is connected to the third data signal line D3, and the fourth sub-pixel P4 is connected to the fourth data signal line D4), one compensation signal line S, and four pixel drive circuits.

In an exemplary implementation, the first scan signal line G1 and the second scan signal line G2 may extend along the first direction D1 and are sequentially arranged along the second direction D2, wherein the first direction D1 intersects with the second direction D2. The first power supply line VDD, the data signal lines D, and the compensation signal line S may extend along the second direction D2 and are correspondingly disposed along the first direction D 1.

In an exemplary implementation, four data signal lines D and one compensation signal line S are disposed between the first power supply line VDD and the second power supply line VSS, two of the four data signal lines D are disposed between the compensation signal line S and the first power supply line VDD, and the other two of the four data signal line D are disposed between the compensation signal line S and the second power supply line VSS. Thus, four sub-pixels are formed between the first power supply line VDD and the second power supply line VSS by providing the four data signal lines D and the one compensation signal line S. Correspondingly, four sub-pixels are also formed between two compensation signal lines S by providing one first power supply line VDD, one second power supply line VSS and four data signal lines D.

In an exemplary implementation, one first power supply line VDD, two data signal lines D, one compensation signal line S, other two data signal lines D, and one first power supply line VSS may be arranged in sequence along the first direction D1. In the first direction D1, the first sub-pixel P1 and the second sub-pixel P2 are alternately arranged to form a first row, and the third sub-pixel P3 and the fourth sub-pixel P4 are alternately arranged to form a second row. In the second direction D2, the first sub-pixel P1 and the third sub-pixel P3 are alternately arranged to form a first column, and the second sub-pixel P2 and the fourth sub-pixel P4 are alternately arranged to form a second column.

In an exemplary implementation, among the four sub-pixels of at least one pixel unit, the pixel drive circuit in each sub-pixel may include a first transistor T1, a second transistor T2, a third transistor T3 and a storage capacitor. The first transistor T1 may include a first active layer, a first gate, a first source, and a first drain. The second transistor T2 may include a second active layer, a second gate, a second source, and a second drain. The third transistor T3 may include a third active layer, a third gate, a third source, and a third drain. The storage capacitor may include a first plate and a second plate.

In an exemplary implementation, the first plate and the second plate are transparent conductive layers forming a transparent storage capacitor.

In an exemplary implementation, the first scan signal line G1 is connected to a gate of the first transistor T1 in each sub-pixel, and the second scan signal line G2 is connected to a gate of the third transistor T3 in each sub-pixel. The data signal line D is connected to a first electrode of the first transistor T1 in each sub-pixel, and the compensation signal line S is connected to a first electrode of the third transistor T3 in each sub-pixel. The first power supply line VDD is connected to a first electrode of the second transistor T2 in each sub-pixel. A second electrode of the first transistor T1 in each sub-pixel is connected to a gate of the second transistor T2. A second electrode of the second transistor T2 in each sub-pixel is connected to the first electrode of the third transistor T3 and an anode of the light emitting device. The first plate in each sub-pixel is connected to the second electrode of the second transistor T2 and the second electrode of the third transistor T3 respectively, and the second plate in each sub-pixel is connected to the second electrode of the first transistor T1 and the gate of the second transistor T2, respectively.

In an exemplary implementation, at least one pixel unit may include multiple connection lines, which at least include two transverse power supply connection lines extending along the first direction D 1 and two compensation connection lines extending along an opposite direction of the first direction D1, thereby forming a one-for-four structure of the first power supply line and a one-for-four structure of the compensation signal line.

In an exemplary implementation, one transverse power supply connection line is disposed at the first sub-pixel P1 and the second sub-pixel P2. A first end of the transverse power supply connection line is connected to the first power supply line VDD through a via, and the other end of the transverse power supply connection line is connected to the second transistors T2 in the first sub-pixel P1 and the second sub-pixel P2 through vias. Another transverse power supply connection line is disposed at the third sub-pixel P3 and the fourth sub-pixel P4. One end of the transverse power supply connection line is connected to the first power supply line VDD through a via, and the other end of the transverse power supply connection line is connected to the second transistors T2 in the third sub-pixel P3 and the fourth sub-pixel P4 through vias. In this way, one first power supply line VDD can supply power signals to four sub-pixels.

In an exemplary implementation, a compensation connection line is disposed in the middle of a pixel unit, the compensation connection line and the compensation signal line are connected to each other to form an integrated structure, and the compensation connection line is connected to the third transistor T3 in each sub-pixel through a via. Thus one compensation signal line S can supply compensation signals to four sub-pixels.

In the embodiment of the present disclosure, the quantity of signal lines is saved through the one-for-four structure of the first power supply line and the one-for-four structure of the compensation signal line, thereby reducing the space occupied, implementing a simple structure and a reasonable layout, making full use of the layout space, improving a space utilization rate, which is beneficial to improving a resolution.

In an exemplary implementation, in a direction perpendicular to the display substrate, a drive circuit layer of a sub-pixel may include a first conductive layer, a first insulation layer, a semiconductor layer, a second insulation layer, a second conductive layer, a third insulation layer, a third conductive layer, a fourth insulation layer and a planarization layer which are stacked on the base substrate. The first conductive layer at least includes a first plate of a storage capacitor, a compensation signal line and a compensation connection line. The semiconductor layer at least includes active layers of three transistors. The second conductive layer at least includes a first scan signal line, a second scan signal line, a transverse power supply connection line, a second plate of the storage capacitor and gate electrodes of the three transistors. The third conductive layer at least includes a first power supply line VDD, a second power supply line VSS, a data signal line D and first electrodes and second electrodes of the three transistors. There is at least an overlapped area between an orthographic projection of the first plate on the base substrate and an orthographic projection of the second plate on the base substrate, thereby forming a storage capacitor.

In an exemplary implementation, the second conductive layer may include a first scan connection line and a second scan connection line. The first scan connection line and the second scan connection line are located in the first sub-pixel P1 and the second sub-pixel P2, the first scan signal line and the second scan signal line are located in the third sub-pixel P3 and the fourth sub-pixel P4, and the second scan connection line and the second scan signal line are connected to each other to form an integrated structure.

The third conductive layer may include a third scan connection line electrically connected to the first scan connection line and the first scan signal line through vias respectively.

In an exemplary implementation, the second conductive layer may include a longitudinal power supply connection line and an auxiliary power supply line. The first power supply line VDD is electrically connected to the longitudinal power supply connection line through a via to form a double-layer first power supply trace, and the second power supply line VSS is electrically connected to the auxiliary power supply line through a via to form a double-layer second power supply trace.

In an exemplary implementation, the third conductive layer may include an auxiliary cathode, and the auxiliary cathode and the second power supply line VSS are connected to each other to form an integrated structure.

In an exemplary implementation, in a direction perpendicular to the display substrate, the sub-pixel further includes a light emitting structure layer disposed at a side of the drive circuit layer away from the base substrate. The light emitting structure layer includes an anode, and an auxiliary connection electrode is disposed in a same layer as the anode.

Exemplary description is made below through a manufacturing process of a display substrate. A "patterning process" mentioned in the present disclosure includes coating with a photoresist, mask exposure, development, etching, photoresist stripping, and other treatments for a metal material, an inorganic material, or a transparent conductive material, and includes coating with an organic material, mask exposure, development, and other treatments for an organic material. Deposition may be any one or more of sputtering, evaporation, and chemical vapor deposition. Coating may be any one or more of spray coating, spin coating, and ink-jet printing. Etching may be any one or more of dry etching and wet etching, which is not limited in present disclosure. A "thin film" refers to a layer of thin film made of a material on a base substrate through a process such as deposition, coating, etc. If the "thin film" does not need a patterning process in an entire preparation process, the "thin film" may also be called a "layer". If the "thin film" needs a patterning process in an entire preparation process, it is called a "thin film" before the patterning process, and called a "layer" after the patterning process. The "layer" after the patterning process includes at least one "pattern". "A and B being disposed on a same layer" mentioned in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B is within a range of an orthographic projection of A" or "an orthographic projection of A includes an orthographic projection of B" refers to that a boundary of the orthographic projection of B falls within a range of a boundary of the orthographic projection of A, or the boundary of the orthographic projection of A coincides with the boundary of the orthographic projection of B.

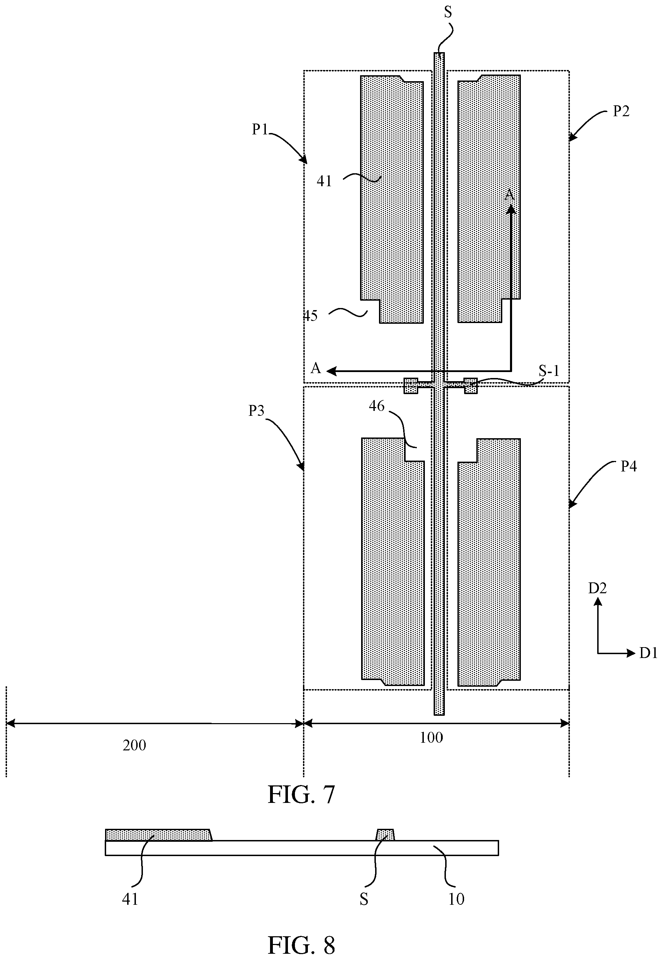

FIGS. 7-26 are schematic diagrams of a manufacturing process of a display substrate according to the present disclosure, illustrating a layout structure of a display unit of a top-emission OLED display substrate, in which each display unit includes a display area 100 and a transparent area 200. The display area 100 includes a first sub-pixel P1, a second sub-pixel P2, a third sub-pixel P3 and a fourth sub-pixel P4. The pixel drive circuit of each sub-pixel includes a first transistor T1, a second transistor T2, a third transistor T3 and a storage capacitor. In an exemplary implementation, the manufacturing process of the display substrate may include following operations.
(1) Forming a pattern of a first conductive layer, including: depositing a first metal thin film on a base substrate, patterning the first metal thin film by a patterning process, and forming a pattern of the first conductive layer on the base substrate 10. The pattern of the first conductive layer includes a first plate 41 and a compensation connection line S, one first plate 41 is formed in each sub-pixel, and the compensation connection line S is a strip-shaped structure disposed among four sub-pixels, as shown in FIGS. 7 and 8, wherein FIG. 8 is a cross-sectional view taken along a direction A-A in FIG. 7.

In an exemplary implementation, the first plate 41 not only serves as a plate of the first capacitor and is configured to form the first capacitor with a second plate to be formed subsequently, the first plate 41 also serves as a shielding layer and is configured to shield light for the transistors to decrease an intensity of light irradiated onto the transistors and reduce the leakage current, thereby reducing an influence of light illuminance on the properties of the transistors.

In an exemplary implementation, the compensation signal line S extends in the second direction D2, and a compensation connection line S-1 protruding in the first direction D1 and in the opposite direction of the first direction D1 is disposed on the compensation signal line S. The compensation connection line S-1 is connected to a first electrode of a third transistor to be formed subsequently for supplying a compensation signal to the third transistor in each sub-pixel.

In an exemplary implementation, the first plate 41 is in a rectangular strip shape. The first plate 41 in the first sub-pixel P1 and the first plate 41 in the second sub-pixel P2 are each provided with a first opening 45 at a position close to the middle of the pixel unit and away from the compensation signal line S. The first plate 41 in the third sub-pixel P3 and the first plate 41 in the fourth sub-pixel P4 are each provided with a second opening 46 at a position close to the middle of the pixel unit and close to the compensation signal line S.

In an exemplary implementation, the pattern of the first conductive layer in the first sub-pixel P1 and the pattern of the first conductive layer in the second sub-pixel P2 are mirror symmetrical with respect to a vertical axis (which may be the compensation signal line S), and the pattern of the first conductive layer in the third sub-pixel P3 and the pattern of the first conductive layer in the fourth sub-pixel P4 are mirror symmetrical with respect to the vertical axis.

After this patterning process, the pattern of the first conductive layer is formed in the display area 100, and there is no corresponding film layer in the transparent area 200.

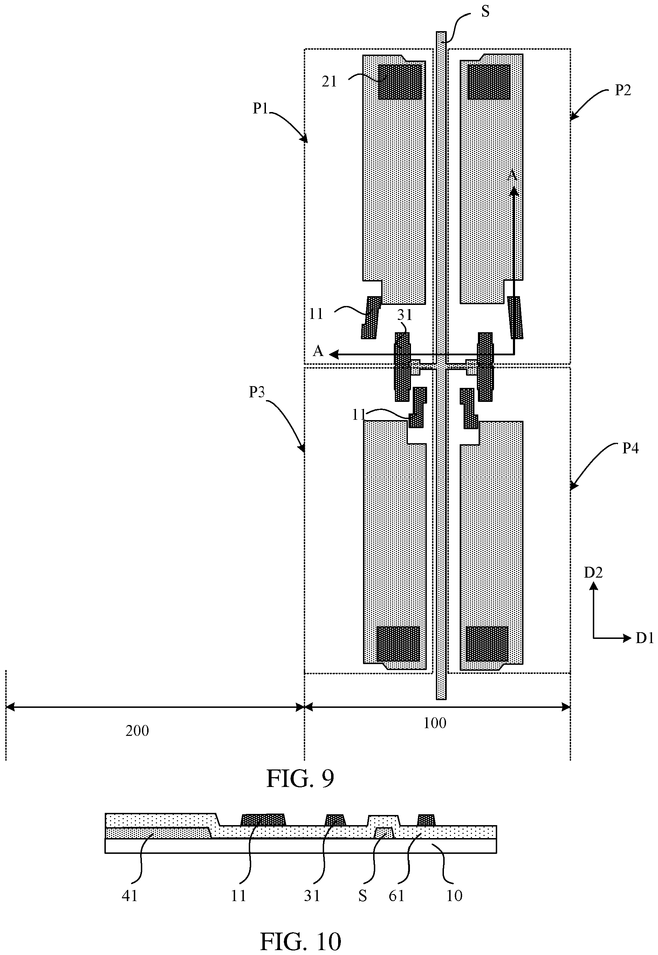

(2) Forming a pattern of a semiconductor layer, including: depositing a first insulation thin film and a semiconductor thin film sequentially on the base substrate on which the above pattern is formed, patterning the semiconductor thin film by a patterning process to form a first insulation layer 61 covering the pattern of the first conductive layer and a pattern of a semiconductor layer on the first insulation layer 61. The semiconductor layer includes patterns of a first active layer 11, a second active layer 21 and a third active layer 31 which are arranged in each sub-pixel, as shown in FIGS. 9 and 10, wherein FIG. 10 is a cross-sectional view taken along direction A-A in FIG. 9. The first active layer 11 serves as an active layer of the first transistor, the second active layer 21 serves as an active layer of the second transistor, and the third active layer 31 serves as an active layer of the third transistor.

In an exemplary implementation, in the four sub-pixels, there is an overlapped area between an orthographic projections of the second active layer 21 on the base substrate 10 and an orthographic projection of the first plate 41 on the base substrate 10, so that the first plate 41 serving as a shielding layer can shield a channel region of the second transistor to prevent the channel from being affected by the light, thereby preventing the channel from affecting the display effect due to generation of photo-generated leakage current.

In an exemplary implementation, the first active layers 11 in the first sub-pixel P1 and the second sub-pixel P2 are disposed at positions close to the first openings 45, and the first active layers 11 in the third sub-pixel P3 and the fourth sub-pixel P4 are disposed at positions disposed close to the second openings 46.

In an exemplary implementation, in the four sub-pixels P1 to P4, each third active layer 31 is disposed at a position close to the compensation connection line S-1, and there is an overlapped area between an orthographic projection of the third active layer 31 on the base substrate 10 and an orthographic projection of the compensation connection line S-1 on the base substrate 10. In an exemplary implementation, the third active layer 31 in the first sub-pixel P1 and the third active layer 31 in the third sub-pixel P3 are connected to each other to form an integrated structure, and the third active layer 31 in the second sub-pixel P2 and the third active layer 31 in the fourth sub-pixel P4 are connected to each other to form an integrated structure.

In an exemplary implementation, the pattern of the semiconductor layer in the first sub-pixel P1 and the pattern of the semiconductor layer in the second sub-pixel P2 are mirror symmetric with respect to the vertical axis, and the pattern of the semiconductor layer in the third sub-pixel P3 and the pattern of the semiconductor layer in the fourth sub-pixel P4 are mirror symmetric with respect to the vertical axis.

In an exemplary implementation, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or multiple layers.

After this patterning process, the pattern of the semiconductor layer is formed in the display area 100, and the transparent area 200 includes the base substrate 10 and the first insulation layer 61 arranged on the base substrate 10.

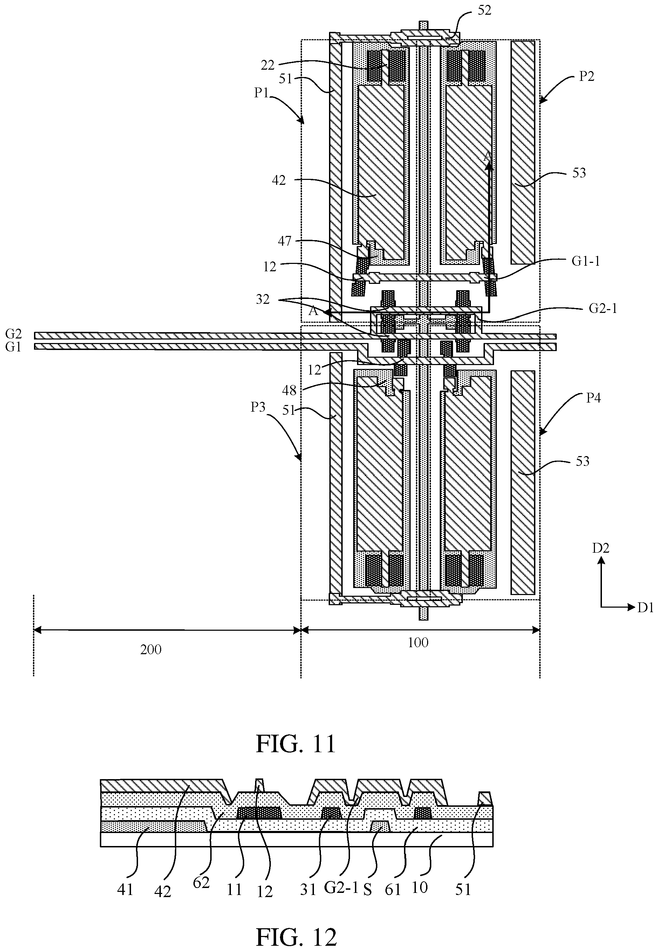

(3) Forming a pattern of a second conductive layer, including: depositing a second insulation thin film and a second metal thin film sequentially on the base substrate on which the above patterns are formed, patterning the second insulation thin film and the second metal thin film by a patterning process to form a pattern of a second insulation layer 62 and a pattern of a second conductive layer disposed on the second insulation layer 62. The pattern of the second conductive layer includes a first scan signal line G1, a second scan signal line G2, a first scan connection line G1-1, a second scan connection line G2-1, a longitudinal power supply connection line 51, a transverse power supply connection line 52 and an auxiliary power supply line 53 which are formed in each display unit, and a second plate 42, a first gate 12, a second gate 22 and a third gate 32 which are formed in each sub-pixel, as shown in FIGS. 11 and 12, wherein FIG. 12 is a cross-sectional view taken along direction A-A in FIG. 11.

In an exemplary implementation, there is an overlapped area between an orthographic projection of the second plate 42 on the substrate 10 and an orthographic projection of the first plate 41 on the base substrate 10, and the first plate 41 and the second plate 42 form a first capacitor.

In an exemplary implementation, the second plate 42 is in a rectangular strip shape. The second plates 42 in the first sub-pixel P1 and the second sub-pixel P2 are each provided with a third opening 47 at a position close to the middle of the pixel unit, the second plates 42 in the third sub-pixel P3 and the fourth sub-pixel P4 are each provided with a fourth opening 48 at a position close to the middle of the pixel unit, respectively.

In an exemplary implementation, the first scan signal line G1 and the second scan signal line G2 each extend along the first direction D1, the second scan connection line G2-1 has an inverted U-shaped structure. The second scan connection line G2-1 and the second scan signal line G2 are connected to each other to form an integrated structure. The first scan connection line G1-1 has a Chinese word "-"-shaped structure. The first scan connection line G1-1 and the second scan connection line G2-1 are located in the first sub-pixel P1 and the second sub-pixel P2, and the first scan signal line G1 and the second scan signal line G2 are located in the third sub-pixel P3 and the fourth sub-pixel P4.

In an exemplary implementation, there is an overlapped area between an orthographic projection of the second scan signal line G2 on the base substrate and an orthographic projection of the third active layers 31 in the third sub-pixel P3 and the fourth sub-pixel P4 on the base substrate. The overlapped area between the second scan signal line G2 and the third active layers 31 in the third sub-pixel P3 and the fourth sub-pixel P4 serves as gates 32 of the third transistors T3 in the third sub-pixel P3 and the fourth sub-pixel P4. There is an overlapped area between an orthographic projection of the second scan connection line G2-1 on the base substrate and an orthographic projection of the third active layers 31 in the first sub-pixel P1 and the second sub-pixel P2 on the base substrate. The overlapped area between the second scan connection line G2-1 and the third active layers 31 in the first sub-pixel P1 and the second sub-pixel P2 serves as gates 32 of the third transistors T3 in the first sub-pixel P1 and the second sub-pixel P2.

In an exemplary implementation, the first scan signal line G1 includes a "U"-shaped bent portion. There is an overlapped area between an orthographic projection of the first scan signal line G1 on the base substrate and an orthographic projection of the first active layers 11 in the third sub-pixel P3 and the fourth sub-pixel P4 on the base substrate. The overlapped area between the first scan signal line G1 and the first active layers 11 in the third sub-pixel P3 and the fourth sub-pixel P4 serves as gates 12 of the first transistors T1 in the third sub-pixel P3 and the fourth sub-pixel P4. There is an overlapped area between an orthographic projection of the first scan connection line G1-1 on the base substrate and an orthographic projection of the first active layers 11 in the first sub-pixel P1 and the second sub-pixel P2 on the base substrate. The overlapped area between the first scan connection line G1-1 and the first active layers 11 in the first sub-pixel P1 and the second sub-pixel P2 serves as gates 12 of the first transistors T1 in the first sub-pixel P1 and the second sub-pixel P2.

In an exemplary implementation, the second gate 22 is provided across the second active layer 21 and is connected with the second plate 42 to form an integrated structure.

In the exemplary embodiment, each display unit includes two longitudinal power supply connection lines 51 formed in the first sub-pixel P1 and the third sub-pixel P3, and the two longitudinal power supply connection lines 51 are each in a strip-shaped structure extending along the second direction D2. In the first sub-pixel P1, the longitudinal power supply connection line 51 is located at a side of the second plate 42 in the opposite direction of the first direction D 1. In the third sub-pixel P3, the longitudinal power supply connection line 51 is located at a side of the second plate 42 in the opposite direction of the first direction D1. The longitudinal power supply connection line 51 is configured to be connected to a first power supply line VDD to be formed subsequently to form a double-layer trace to ensure reliability of transmission of power supply signal and to reduce resistance of the first power supply line.

In an exemplary implementation, two transverse power supply connection lines 52 are included in each display unit. One of the transverse power supply connection lines 52 is located at an upper side of the pixel unit (i.e. at a side of the first sub-pixel P1 and the second sub-pixel P2 away from the third sub-pixel P3 and the fourth sub-pixel P4), the other of the transverse power supply connection lines 52 is located at a lower side of the pixel unit (i.e. at a side of the third sub-pixel P3 and the fourth sub-pixel P4 away from the first sub-pixel P1 and the second sub-pixel P2). Each of the transverse power supply connection lines 52 may be provided with a through hole. There is an overlapped area between an orthographic projection of the through hole on the base substrate and an orthographic projection of the compensation signal line and a data signal line to be formed subsequently on the base substrate, and the through hole is configured to reduce parasitic capacitance between the transverse power supply connection line 52 and the data signal line and the compensation signal line.

In an exemplary implementation, the transverse power supply connection line 52 located at the upper side of the pixel unit may be connected with the longitudinal power supply connection line 51 located in the first sub-pixel P1 to form an integrated structure, and the transverse power supply connection line 52 located at the lower side of the pixel unit may be connected with the longitudinal power supply connection line 51 located in the third sub-pixel P3 to form an integrated structure.

In the exemplary embodiment, each display unit includes two auxiliary power supply lines 53, the two auxiliary power supply lines 53 are formed in the second sub-pixel P2 and the fourth sub-pixel P4 and are each in a strip-shaped structure extending along the second direction D2. In the second sub-pixel P2, the auxiliary power supply line 53 is located at a side of the second plate 42 in the first direction D1. In the fourth sub-pixel P4, the auxiliary power supply line 53 is located at a side of the second plate 42 in the first direction D1. The auxiliary power supply line 53 is configured to be electrically connected to a second power supply line to be formed subsequently to form a double-layer trace to ensure reliability of transmission of power supply signal and to reduce resistance of the second power supply line.

In an exemplary implementation, the pattern of the second insulation layer 62 may be the same as the pattern of the second conductive layer, i.e., the second insulation layer 62 is located below the second conductive layer (i.e., at a side of the second conductive layer close to the base substrate), and there is no second insulation layer 62 in an area other than the second conductive layer.

In an exemplary implementation, the first gates 12, the second gates 22 and the third gates 32 in the first sub-pixel P1 and the second sub-pixel P2 are respectively mirror symmetric with respect to the vertical axis, and the first gates 12, the second gates 22 and the third gates 32 in the third sub-pixel P3 and the third sub-pixel P4 are respectively mirror symmetric with respect to the vertical axis.

In an exemplary implementation, this process further includes a metallization process. Conduction treatment is to perform plasma treatment by using the first gates 12, the second gates 22 and the third gates 32 as a shield after the formation of the pattern of the second conductive layer. The semiconductor layer in an area shielded by the first gates 12, the second gates 22 and the third gates 32 (i.e., an area of the semiconductor layer overlapped with the first gates 12, the second gates 22 and the third gates) serves as channel regions of the transistors, and the semiconductor layer in an area not shielded by the second conductive layer is treated into a conductive layer to form conductive source and drain regions.

After this patterning process, the pattern of the second conductive layer is formed in the display area 100, and the transparent area 200 includes the base substrate 10, the first insulation layer 61 and the second insulation layer 62 stacked on the base substrate 10, and the first scan signal line G1 and second scan signal line G2 disposed on the second insulation layer 62.

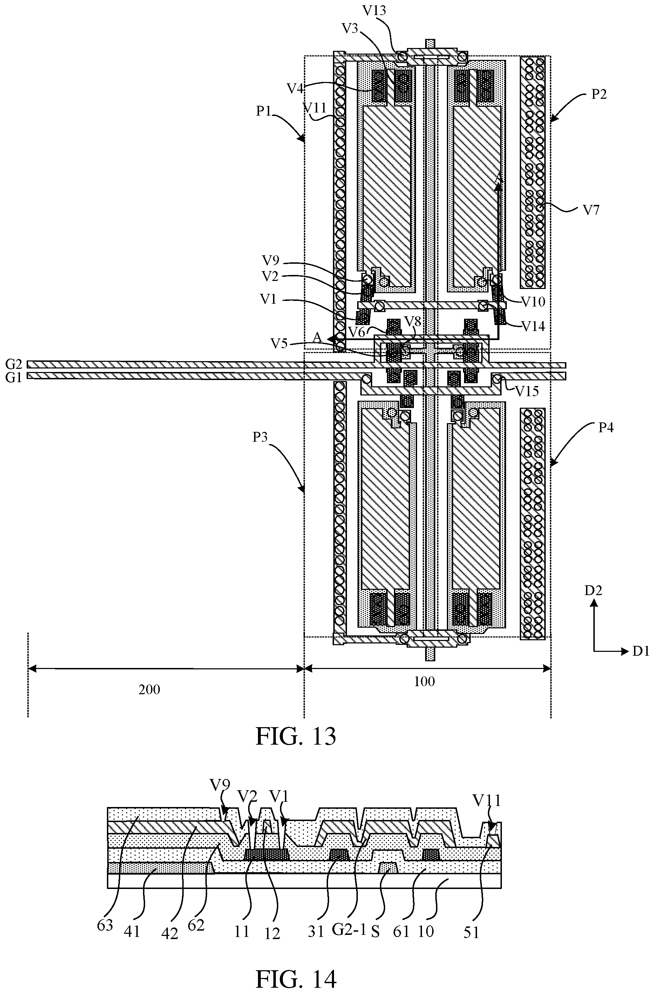

(4) Forming a pattern of a third insulation layer, including: depositing a third insulation thin film on the base substrate on which the above patterns are formed, patterning the third insulation thin film by a patterning process to form a pattern of a third insulation layer 63 covering the above structure. The third insulation layer 63 is provided with patterns of multiple vias, which include: a first via V1 and a second via V2 located on the two sides of the first gate 12, a third via V3 and a fourth via V4 located on the two sides of the second gate 22, a fifth via V5 and a sixth via V6 located on the two sides of the third gate 32, multiple seventh via V7 located at the position of the auxiliary power supply line 53, an eighth via V8 located in a position of the compensation connection line S-1, a ninth via V9 located in an overlapped area between the first drain 14 to be formed subsequent and the second plate 42, a tenth via V10 located on the first electrode plate 41 and overlapped with an opening area on the second electrode plate 42, multiple eleventh vias V11 located at a position of the longitudinal power supply connection line 51, a thirteenth via V13 located at a position of the transverse power supply connection line 52, a fourteenth via V14 located at a position of the first scan connection line G1-1, and a fifteenth via V15 located at a position of the first scan signal line G1, as shown in FIG. 13 and FIG. 14, wherein FIG. 14 is a cross-sectional view taken along direction A-A in FIG. 13.

The third insulation layer 63 in the first via V1 and the second via V2 is etched away to expose surfaces at both ends of the first active layer 11. The third insulation layer 63 in the third via V3 and the fourth via V4 is etched away to expose surfaces at both ends of the second active layer 21. The third insulation layer 63 in the fifth via V5 and the sixth via V6 is etched away to expose surfaces at both ends of the third active layer 31. The seventh vias V7 are located at the position of the auxiliary power supply line 53, the multiple seventh vias V7 are arranged at intervals, and the third insulation layer 63 in the seventh vias V7 is etched away to expose a surface of the auxiliary power supply line 53. The eighth via V8 is located at a position where the third source 33 to be formed subsequently is overlapped with the compensation connection line S-1, and the first insulation layer 61 and the third insulation layer 63 in the eighth via V8 are etched away to expose a surface of the compensation connection line S-1. The ninth via V9 is formed on the second plate 42, and the third insulation layer 63 in the ninth via V9 is etched away to expose a surface of the second plate 42. The tenth vias V10 in the first sub-pixel P1 and the second sub-pixel P2 are located in positions of the third openings 47 of the second plate 42, the tenth vias V10 in the third sub-pixel P3 and the fourth sub-pixel P4 are each located at a position of the fourth opening 48 of the second plate 42, and the first insulation layer 61 and the third insulation layer 63 in the tenth via V10 are etched away to expose a surface of the first plate 41. The eleventh vias V11 is located at a position of the longitudinal power supply connection line 51, the multiple eleventh vias V11 are arranged at intervals, and the third insulation layer 63 in the eleventh vias V11 is etched away to expose a surface of the longitudinal power supply connection line 51. The thirteenth via V13 is located at a position of an overlapped area between the transverse power supply connection line 52 and the second source 23 to be formed subsequently, and the third insulation layer 63 in the thirteenth via V13 is etched away to expose a surface of the transverse power supply connection line 52. The fourteenth via V14 is located at a position of an overlapped area between the first scan connection line G1-1 and the third scan connection line 54 to be formed subsequently, and the third insulation layer 63 in the fourteenth via V14 is etched away to expose a surface of the first scan connection line G1-1. The fifteenth via V15 is located at a position of the overlapped area between the first scan signal line G1 and the third scan connection line 54 to be formed subsequently, and the third insulation layer 63 in the fifteenth via V15 is etched away to expose a surface of the first scan signal line G1.

After this patterning process, patterns of multiple vias are formed in the display area 100, and the transparent area 200 includes a first insulation layer 61 and a second insulation layer 62 stacked on the base substrate 10, a first scan signal line G1 and a second scan signal line G2 disposed on the second insulation layer 62, and a third insulation layer 63 covering the first scan signal line G1 and the second scan signal line G2.

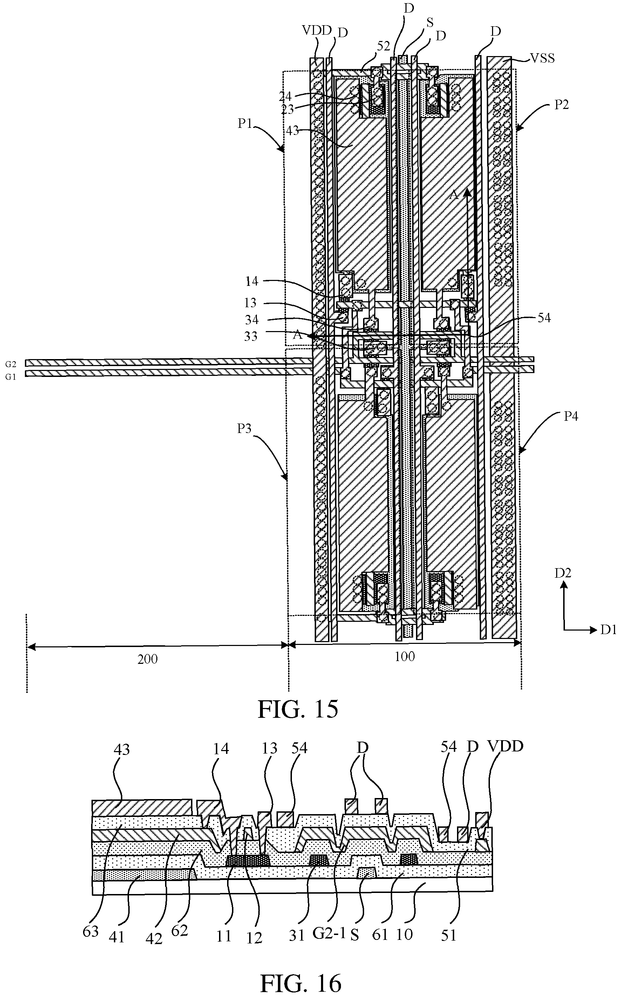

(5) Forming a pattern of a third conductive layer, including: depositing a third metal thin film on the base substrate on which the aforementioned patterns are formed, and patterning the third metal thin film by a patterning process to form a pattern of a third conductive layer on the third insulation layer 63. The third conductive layer includes: one first power supply line VDD, one second power supply line VSS, four data signal lines D and two third scan connection lines 54 formed in each display unit, and patterns of a first source 13, a first drain 14, a second source 23, a second drain 24, a third source 33, a third drain 34 and a third plate 43 formed in each sub-pixel, as shown in FIGS. 15 and 16, wherein FIG. 16 is cross-sectional view taken along direction A-A in FIG. 15.

In an exemplary implementation, the first power supply line VDD, the second power supply line VSS, the compensation signal line S and the data signal line D are arranged in parallel and all extend along the second direction D2. The second power line VSS is disposed within the second sub-pixel P2 and the fourth sub-pixel P4, the first power supply line VDD is disposed within the first sub-pixel P1 and the third sub-pixel P3, the compensation signal line S is disposed between the first power supply line VDD and the second power supply line VSS, two of the data signal lines D are disposed between the second power supply line VSS and the compensation signal line S, and the other two of the data signal lines D are disposed between the first power supply line VDD and the compensation signal line S.

In an exemplary implementation, the first power supply line VDD is connected to the longitudinal power supply connection line 51 and the transverse power supply connection line 52 through multiple eleventh vias V11, the transverse power supply connection line 52 is connected to the second source 23 of each sub-pixel through a thirteenth via V13, the second source 23 is connected to one end of the second active layer 21 through the third via V3, thereby realizing the connection between the second source 23 and the first power supply line VDD. The first power supply line VDD and the longitudinal power supply connection line 51 form a double-layer trace, thereby ensuring the reliability of transmission of power supply signal and reducing the resistance of the first power supply line VDD.

In an exemplary implementation, the second power supply line VSS is connected to the auxiliary power supply line 53 through multiple seventh vias V7, so that the second power supply line VSS and the auxiliary power supply line 53 form a double-layer trace, thereby ensuring the reliability of transmission of power supply signal and reducing the resistance of the second power supply line VSS. In some possible implementations, widths of the first power supply line VDD and the second power supply line VSS along the first direction D1 are both greater than a width of the compensation signal line S along the first direction D1, and the widths of the first power supply line VDD and the second power supply line VSS along the first direction D 1 are both greater than a width of a data signal line D along the first direction D1, such that the resistances of the first power supply line VDD and the second power supply line VSS can be further reduced.

In the exemplary embodiment, the compensation connection line S-1 is connected to the third source 33 of each sub-pixel through the eighth via V8. Since the compensation connection line S-1 is disposed in the middle of the upper sub-pixels and the lower sub-pixels of the display area 100, the compensation signal line S is disposed in the middle of the left sub-pixels and the right sub-pixels of the display area 100, the compensation connecting line S-1 and the compensation signal line S are connected to each other to form an integrated structure, the third transistors of the left sub-pixels and the right sub-pixels are symmetrically arranged with respect to the compensation signal line S, and such symmetrical design makes each display unit only need to use one compensation signal line S, which can ensure that the RC delay of the compensation signal before writing into the transistor is basically the same, and ensure the display uniformity.

In the exemplary embodiment, the third scan connection line 54 is a straight line or a broken line structure extending in the second direction D2, and the third scan connection line 54 is connected to the first scan connection line G1-1 through the fourteenth via V14, and the third scan connection line 54 is connected to the first scan signal line G1 through the fifteenth via V15.

In an exemplary implementation, the data signal line D of the first sub-pixel P1 is disposed at a side of the first sub-pixel P1 close to the first power supply line VDD, the data signal line D of the second sub-pixel P2 is disposed at a side of the second sub-pixel P2 close to the second power supply line VSS, the data signal line D of the third sub-pixel P3 is disposed at a side of the third sub-pixel P3 close to the compensation signal line S, and the data signal line D of the fourth sub-pixel P4 is disposed at a side of the fourth sub-pixel P4 close to the compensation signal line S.

In an exemplary implementation, the first source 13 is connected to a data signal line D to formed an integrated structure with the data signal line, so that each data signal line D is connected to the first source 13 of the sub-pixel in which the data signal line is located. The first source 13 is connected to one end of the first active layer 11 through the first via V1, the first drain 14 is connected to the other end of the first active layer 11 through the second via V2, and the first drain 14 is connected to the second gate 22 and the second plate 42 through the ninth via V9, thus enabling the first drain 14, the second gate 22 and the second plate 42 to have a same potential. The second source 23 is connected to one end of the second active layer 21 through the third via V3, the second source 23 is connected to the first power supply line VDD through the thirteenth via V13, and the transverse power supply line 52 is connected to the first power supply line VDD through the eleventh via V11, thereby realizing the connection between the second source 23 and the first power supply line VDD. The second drain 24 is connected to the other end of the second active layer 21 through the fourth via V4, the third source 33 is connected to one end of the third active layer 31 through the fifth via V5 and also connected to the compensation connection line S-1 through the eighth via V8, the compensation connection line S-1 and the compensation signal line S are connected to each other to form an integrated structure, thereby realizing the connection between the third source 33 and the compensation signal line S. The third drain 34 is connected to the other end of the third active layer 31 through the sixth via V6. The second drain 24, the third drain 34 and the third plate 43 are connected to each other to form an integrated structure, and the third plate 43 is connected to the first plate 41 through the tenth via V10. Therefore, the second drain 24 is respectively connected to the first plate 41 and the third plate 43, and the third drain 34 is respectively connected to the first plate 41 and the third plate 43, such that the second drain 24, the third drain 34, the first plate 41 and the third plate 43 to have a same potential. There is an overlapped area between an orthographic projection of the third plate 43 on the base substrate 10 and an orthographic projection of the second plate 42 on the base substrate 10, and the third plate 43 and the second plate 42 form the second capacitor.

In an exemplary implementation, the first sources 13, the first drains 14, the second sources 23, the second drains 24, the third sources 33, the third drains 34 and the third plates 43 in the first sub-pixel P1 and the second sub-pixel P2 are respectively mirror symmetric with respect to the vertical axis. The first sources 13, the first drains 14, the second sources 23, the second drains 24, the third sources 33, the third drains 34 and the third plates 43 in the third sub-pixel P3 and the fourth sub-pixel P4 are mirror symmetric with respect to the vertical axis.

After this patterning process, the pattern of the third conductive layer is formed in the display area 100, and the transparent area 200 includes the first insulation layer 61 and the second insulation layer 62 stacked on the base substrate 10, the first scan signal line G1 and the second scan signal line G2 disposed on the second insulation layer 62, and the third insulation layer 63 covering the first scan signal line G1 and the second scan signal line G2.

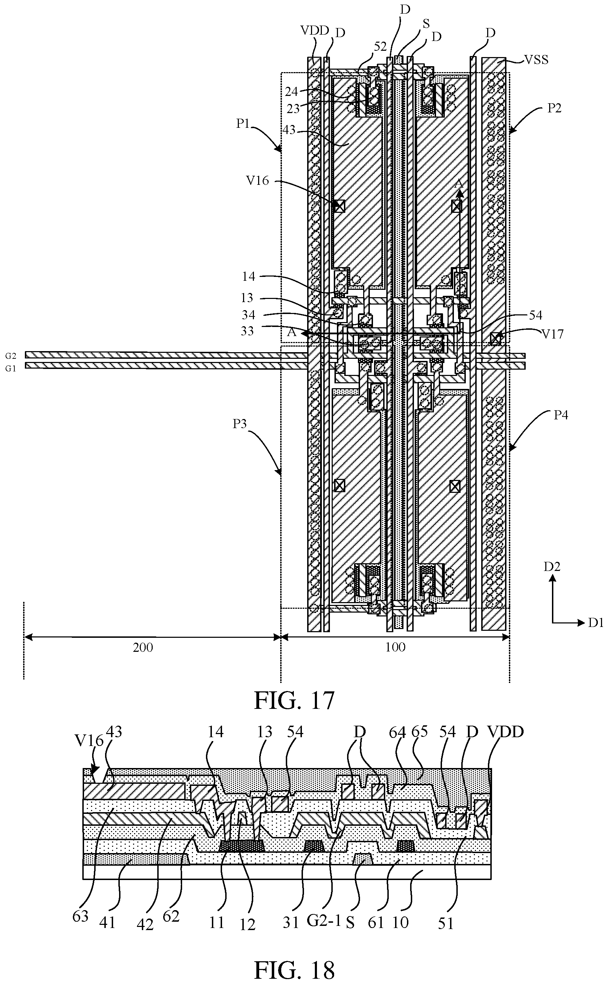

(6) Forming patterns of a fourth insulation layer and a planarization layer, including: first depositing a fourth insulation thin film on the base substrate on which the above patterns are formed, then coating a planarization thin film, and etching the fourth insulation thin film through masking, exposure and development of the planarization thin film to form a pattern of a fourth insulation layer 64 covering the above structures and a pattern of a planarization layer (PLN) 65 arranged on the fourth insulation layer 64. The fourth insulation layer 64 and the planarization layer 65 are provided with patterns of multiple vias, which at least include: a sixteenth via V16 located at the position of the third plate 43 in each sub-pixel of the display area 100 and a seventeenth via V17 on the second power supply line VSS, as shown in FIGS. 17 and 18, wherein FIG. 18 is a cross-sectional view taken along direction A-A in FIG. 17.

In an exemplary implementation, the sixteenth via V16 is located in the middle of the third plate 43, the fourth insulation layer 64 and the planarization layer 65 in the sixteenth via V16 are etched away to expose a surface of the third plate 43, and the fourth insulation layer 64 and the planarization layer 65 in the seventeenth via V17 are etched away to expose a surface of the second power supply line VSS.

After this composition process, the transparent area 200 includes the first insulation layer 61 and the second insulation layer 62 stacked on the base substrate 10, the first scan signal line G1, the second scan signal line G2 disposed on the second insulation layer 62, the third insulation layer 63 covering the first scan signal line G1 and the second scan signal line G2, and the fourth insulation layer 64 and the planarization layer 65 disposed on the third insulation layer 63.

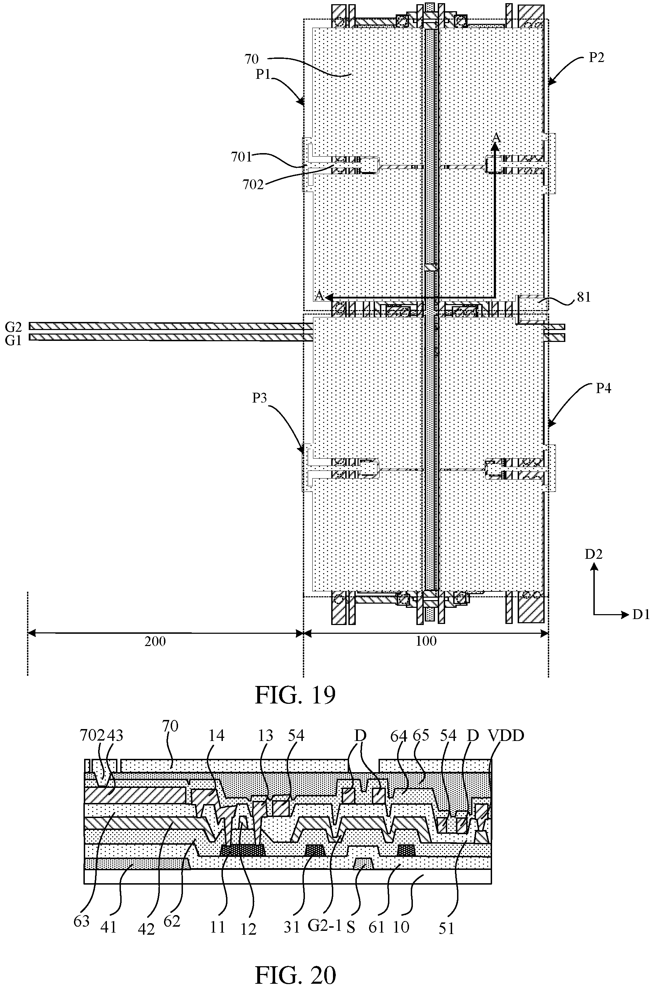

(7) Forming a pattern of a first transparent conductive layer, including: depositing a first transparent conductive thin film on the base substrate on which the above patterns are formed, patterning the first transparent conductive thin film by a patterning process to form a pattern of a first transparent conductive layer on the planarization layer 65. The first transparent conductive layer includes a first anode 70 and a first connection electrode 81. The first anode 70 is formed in each sub-pixel of the display area 100, the first anode 70 in each sub-pixel is connected to the drain of the second transistor T2 through the sixteenth via V16 in the corresponding sub-pixel. The first connection electrode 81 is formed at the position of the seventeenth via V17 on the second power supply line VSS in the display area 100, and first connection electrode 81 is connected to the second power supply line VSS through the seventeenth via V17, as shown in FIGS. 19 and 20, wherein FIG. 20 is a cross-sectional view taken along direction A-A in FIG. 19. The drain of the second transistor T2, the drain of the third transistor T3 and the third plate 43 in each sub-pixel are connected to each other to form an integrated structure, such that the first anode 70 is connected to the drain of the second transistor T2 in each sub-pixel. In an exemplary implementation, the four first anodes 70 may form a red light emitting unit, a green light emitting unit, a blue light emitting unit and a white light emitting unit.

In an exemplary implementation, the first anode 70 may include two sub-anode blocks disposed separately and a connection structure connected to the two sub-anodes respectively, and the two sub-anodes are connected to each other through the connection structure. As shown in FIG. 19, the connection structure may include a first connection electrode 701 having a U-shaped structure and a second connection electrode 702. Two ends of the first connection electrode 701 are respectively connected to one of the two sub-anode blocks. One end of the second connection electrode 702 is connected to a drive transistor, and the other end of the second connection electrode 702 is connected to the first connection electrode 701, so that the two sub-anode blocks are connected to each other through the connection structure.

If dark or bright spots appear in any one sub-pixel of the display panel, then a portion of the first connection electrode 701 in the connection structure may be laser cut, whereby one of the two sub-anode blocks from one sub-pixel may be electrically connected to the drive transistor, and the other sub-anode block is floated, such that the sub-pixel may be normally driven.

In an exemplary implementation, the four first anodes 70 are arranged in a square. The upper left first anode 70 is connected to the third plate 43 of the first sub-pixel P1 through the sixteenth via V16 of the first sub-pixel P1, the upper right first anode 70 is connected to the third plate 43 of the second sub-pixel P2 through the sixteenth via V16 of the second sub-pixel P2, the lower left first anode 70 is connected to the third plate 43 of the third sub-pixel P3 through the sixteenth via V16 of the third sub-pixel P3, and the lower right first anode 70 is connected to the third plate 43 of the fourth sub-pixel P4 through the sixteenth via V16 of the fourth sub-pixel P4. In some possible implementations, the arrangement of the first anodes 70 in the display area 100 may be adjusted according to actual needs, which is not limited herein in the present disclosure.

After this patterning process, the transparent area 200 includes the first insulation layer 61 and the second insulation layer 62 stacked on the base substrate 10, the first scan signal line G1 and the second scan signal line G2 disposed on the second insulation layer 62, the third insulation layer 63 covering the first scan signal line G1 and the second scan signal line G2, and the fourth insulation layer 64 and the planarization layer 65 disposed on the third insulation layer 63.

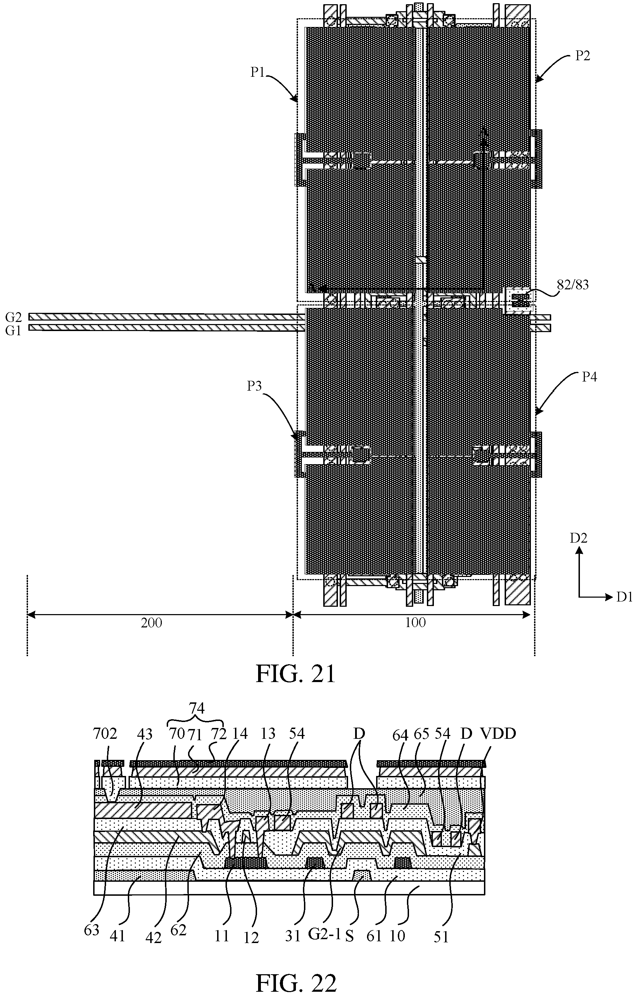

(8) Forming a pattern of an anode. In an exemplary implementation, forming the pattern of the anode may include: sequentially depositing a fourth metal thin film and a second transparent conductive thin film on the base substrate on which the foregoing patterns are formed, and patterning the fourth metal thin film and the second transparent conductive thin film by a patterning process to form patterns of a second anode 71, a third anode 72, a second connection electrode 82 and a third connection electrode 83. The second anode 71 is disposed at a side of the first anode 70 away from the base substrate and is connected to the first anode 70. The third anode 72 is disposed at a side of the second anode 71 away from the base substrate and is connected to the second anode 71. The second connection electrode 82 is disposed at a side of the first connection electrode 81 away from the base substrate and is connected to the first connection electrode 81. The third connection electrode 83 is disposed at a side of the second connection electrode 82 away from the base substrate and is connected to the second connection electrode 82. The first anode 70, the second anode 71, and the third anode 72 are stacked to form an anode 74. The first connection electrode 81, the second connection electrode 82, and the third connection electrode 83 are stacked to form an auxiliary connection electrode, as shown in FIGS. 21 and 22, wherein FIG. 22 is a cross-sectional view taken along direction A-A in FIG. 21.

In an exemplary implementation, in a plane parallel to the display substrate, shapes of the second anode 71 and the third anode 72 are similar to a shape of the first anode 70, an orthographic projection of the second anode 71 on the base substrate may be within a range of an orthographic projection of the first anode 70 on the base substrate, and the orthographic projection of the second anode 71 on the base substrate may be within a range of an orthographic projection of the third anode 72 on the base substrate. In a plane parallel to the display substrate, shapes of the second connection electrode 82 and the third connection electrode 83 are similar to a shape of the first connection electrode 81, an orthographic projection of the second connection electrode 82 on the base substrate may be within a range of an orthographic projection of the first connection electrode 81 on the base substrate, and the orthographic projection of the second connection electrode 82 on the base substrate may be within a range of an orthographic projection of the third connection electrode 83 on the base substrate.

In an exemplary implementation, in a plane perpendicular to the display substrate, the first connection electrode 81 located at a side (lower side) of the second connection electrode 82 close to the base substrate has an edge protruding from a contour of the second connection electrode 82, forming a "roof seat" structure, the third connection electrode 83 located at a side (upper side) of the second connection electrode 82 away from the base substrate has an edge protruding from the contour of the second connection electrode 82, the first connection electrode 81 and the third connection electrode 83 form an "eave" structure, so that the stacked first connection electrode 81, the second connection electrode 82 and the third connection electrode 83 form a structure with a shape like a letter "I".

In an exemplary implementation, the first anode 70 located at a side (lower side) of the second anode 71 close to the base substrate has an edge protruding from a contour of the second anode 71, forming a "roof seat" structure, the third anode 72 located at a side (upper side) of the second anode 71 away from the base substrate has an edge protruding from a contour of the second anode 71, forming an "eave" structure, so that the stacked first anode 70, second anode 71 and third anode 72 form a structure with a shape like a letter "I".

In an exemplary implementation, in a process of patterning the fourth metal thin film and the second transparent conducting thin film, a first etchant and a second etchant may be used for etching respectively, and a structure, with a shape like a letter "I", of the auxiliary electrode and the anode can be formed by drilling. In an exemplary implementation, the first etchant may be an etchant (ITO etchant) for etching a transparent conducting material, and the second etchant may be an etchant (metal etchant) for etching a metal material. In an exemplary implementation, after a photoresist pattern is formed by masking, exposing and developing the photoresist, the etching process may include: firstly etching the second transparent conductive thin film which is not covered by the photoresist by using the ITO etchant, so that an area not covered by the photoresist exposes the fourth metal thin film, to form patterns of the third anode 72 and the third connection electrode 83. Then, the exposed fourth metal thin film is etched using the metal etchant to form patterns of the second anode 71 and the second connection electrode 82. Since a rate of etching the fourth metal thin film by the metal etchant is higher than a rate of etching the first transparent conductive thin film and the second transparent conductive thin film, side surfaces of the second anode 71 and the second connection electrode 82 are etched into pits. The first anode 70 below the second anode 71 and the third anode 72 above the second anode 71 both protrude from the second anode 71 by a certain distance, while the first connection electrode 81 below the second connection electrode 82 and the third connection electrode 83 above the second connection electrode 82 protrude from the second connection electrode 82 by a certain distance, forming a structure with a shape like a letter "I".

In an exemplary implementation, a material of the fourth metal film may include any one or more of silver (Ag), copper (Cu), aluminum (Al), titanium (TI), and molybdenum (Mo), or an alloy material of the above metals, and a second transparent conductive material may be indium tin oxide (ITO) or indium zinc oxide (IZO), etc.

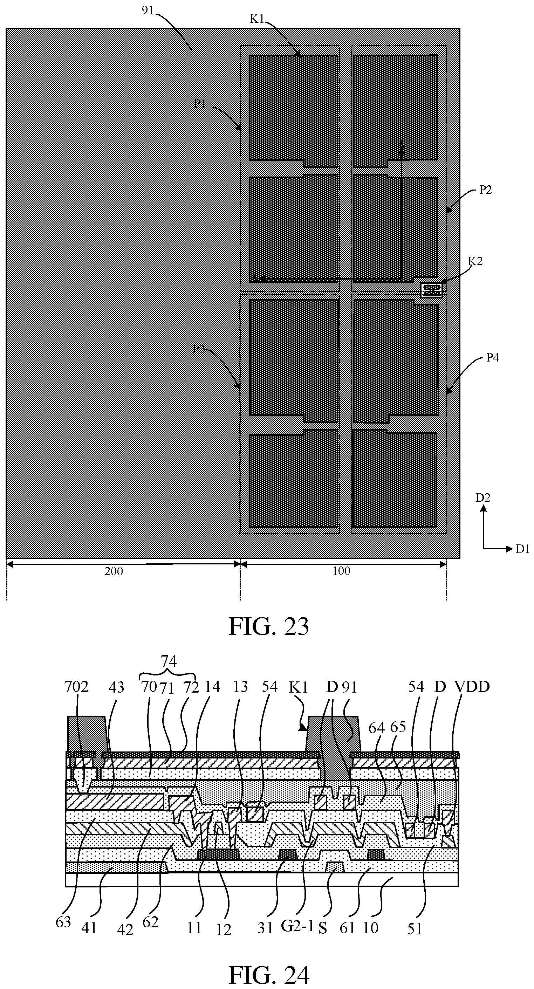

(9) Forming a pattern of a pixel definition layer. In an exemplary implementation, forming the pattern of the pixel definition layer may include: coating a pixel definition thin film on the base substrate on which the above patterns are formed, and patterning the pixel definition thin film by a patterning process to form the pattern of the pixel definition layer (PDL) 91. The pixel definition layer 91 is provided with a first pixel opening K1 and a second auxiliary electrode opening K2. The pixel definition layer 91 in the first pixel opening K1 is removed to expose part of a surface of the third anode 72 in the anode, and the pixel definition layer 91 in the second auxiliary electrode opening K2 is removed to expose entire surfaces of the second connection electrode 82 and the third connection electrode 83 in the auxiliary connection electrode, as illustrated in FIGS. 23 and 24, wherein FIG. 24 is a cross-sectional view taken along direction A-A in FIG. 23.

In an exemplary implementation, an orthographic projection of the first pixel opening K1 on the base substrate is within a range of the orthographic projection of the third anode 72 on the base substrate, an orthographic projection of the second auxiliary electrode opening K2 on the base substrate is within a range of the orthographic projection of the first connection electrode 81 on the base substrate, and the orthographic projections of the second connection electrode 82 and the third connection electrode 83 on the base substrate are within the range of the orthographic projection of the second auxiliary electrode opening K2 on the base substrate. The second auxiliary electrode opening K2 exposing entire surfaces of the second connection electrode 82 and the third connection electrode 83 means that the second auxiliary electrode opening has a second lower opening close to the base substrate and a second upper opening away from the base substrate, the orthographic projections of the second connection electrode 82 and the third connection electrode 83 on the base substrate are within a range of an orthographic projection of the second lower opening on the base substrate.

In an exemplary implementation, the pixel definition layer may be made of polyimide, acrylic, polyethylene terephthalate, or the like. In a plane parallel to the display substrate, a shape of the first pixel opening K1 may be similar to a shape of multiple anode blocks, and a shape of the second auxiliary electrode opening K2 may be a rectangle. In a plane perpendicular to the display substrate, cross-sectional shapes of the first pixel opening K1 and the second auxiliary electrode opening K2 may be a rectangle or a trapezoid.

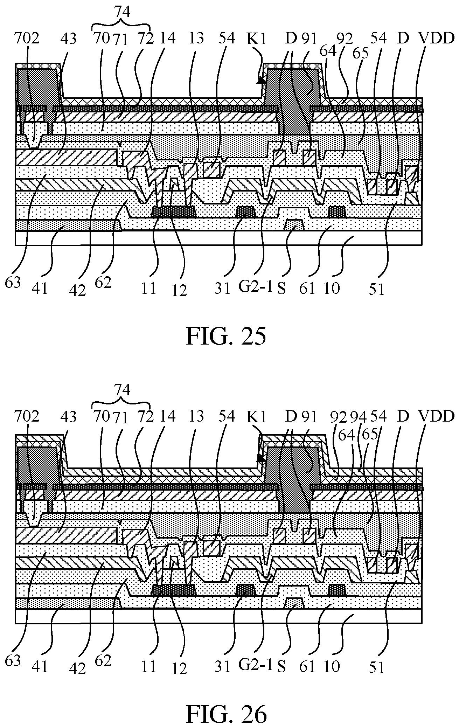

(10) Forming a pattern of an organic emitting layer. In an exemplary implementation, forming the pattern of the organic light emitting layer may include: evaporating an organic light emitting material on the base substrate on which the above patterns are formed to form patterns of an organic light emitting layer 92 and an organic light emitting block. The organic light emitting layer 92 is disposed in a region outside the third connection electrode 83, the organic light emitting layer 92 is connected to the third anode 72 in the anode 74 through the first pixel opening K1, the organic light emitting block is disposed on a surface of the third connection electrode 83 away from the base substrate, and the organic light emitting block is disposed to be isolated from the organic light emitting layer 92, as illustrated in FIG. 25.

In some other exemplary implementations, the pattern of the organic light emitting layer may also be formed by ink jet printing, which is not limited in the embodiments of the present disclosure.

In an exemplary implementation, due to a structure with a shape like a letter "I" of the auxiliary electrode, the third connection electrode 83 protrudes from the second connection electrode 82 by a certain distance, so the organic light emitting material is broken at a side edge of the third connection electrode 83, the organic light emitting blockis formed on a second upper surface of the third connection electrode 83, and the organic light emitting layer 92 is formed in the region outside the third connection electrode 83, thus achieving the mutual isolation between the organic light emitting layer 92 and the organic light emitting block. In an exemplary implementation, an orthographic projection of the organic light emitting block on the base substrate may be approximately equal to an orthographic projection of the third connection electrode on the base substrate. The organic light emitting layer is separated by the auxiliary electrode of a structure with a shape like a letter "I" to form an isolated and separated organic light emitting block, which effectively avoids the interference of the organic light emitting block with emitted light, thereby improving the quality of the emitted light and facilitating improvement of the display quality.

In an exemplary implementation, the organic light emitting layer may include an emitting layer (EML) and any one or more of the following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, the organic light emitting layer may be formed by evaporation using a Fine Metal Mask (FMM) or an open mask, or by an inkjet process.

In an exemplary implementation, the organic emitting layer may be manufactured through a following manufacturing method. First, a hole injection layer and a hole transport layer are sequentially evaporated by using an open mask, and a common layer of the hole injection layer and the hole transport layer is formed on the display substrate. Then, by using a fine metal mask, an electron block layer and a red emitting layer are evaporated in a red sub-pixel, an electron block layer and a green emitting layer are evaporated in a green sub-pixel, and an electron block layer and a blue emitting layer are evaporated in a blue sub-pixel. Electron block layers and emitting layers of adjacent sub-pixels may be overlapped slightly (for example, an overlapping portion accounts for less than 10% of an area of a pattern of a respective emitting layer), or may be isolated. Then, a hole block layer, an electron transport layer, and an electron injection layer are sequentially evaporated by using an open mask, and a common layer of the hole block layer, the electron transport layer, and the electron injection layer is formed on the display substrate.

In an exemplary implementation, an electron block layer may be used as a micro-cavity adjustment layer of a light emitting device. By designing a thickness of an electron block layer, a thickness of the organic emitting layer between the cathode and the anode may satisfy a design for a length of a micro-cavity. In some exemplary implementations, the hole transport layer, the hole block layer, or the electron transport layer in the organic emitting layer may be used as a micro-cavity adjustment layer of a light emitting device, which is not limited in the present disclosure.

In an exemplary implementation, an emitting layer may include a host material and a dopant material doped into the host material. A doping ratio of the dopant material of the emitting layer is 1% to 20%. Within a range of the doping ratio, on one hand, the host material of the emitting layer may effectively transfer exciton energy to the dopant material of the emitting layer to excite the dopant material of the emitting layer to emit light. On the other hand, the host material of the emitting layer "dilutes" the dopant material of the emitting layer, thus effectively improving fluorescence quenching caused by collisions between molecules of the dopant material of the emitting layer and collisions between energies, and improving a luminous efficiency and device life. In an exemplary implementation, the doping ratio refers to a ratio of a mass of the dopant material to a mass of the emitting layer, that is, a mass percentage. In an exemplary implementation, the host material and the dopant material may be co-evaporated through a multi-source evaporation process, so that the host material and the dopant material are uniformly dispersed in the emitting layer. A doping ratio may be adjusted by controlling an evaporation rate of the dopant material or by controlling an evaporation rate ratio of the host material to the dopant material during an evaporation process. In an exemplary implementation, a thickness of the emitting layer may be about 10 nm to 50 nm.

In an exemplary implementation, the hole injection layer may be made of an inorganic oxide, such as molybdenum oxide, titanium oxide, vanadium oxide, rhenium oxide, ruthenium oxide, chromium oxide, zirconium oxide, hafnium oxide, tantalum oxide, silver oxide, tungsten oxide, or manganese oxide, or may be made of a p-type dopant of a strongly electron withdrawing system and a dopant of a hole transport material. In an exemplary implementation, a thickness of the hole injection layer may be about 5 nm to 20 nm.

In an exemplary implementation, the hole transport layer may be made of a material with a relatively high hole mobility, such as an aromatic amine compound, and its substituent group may be carbazole, methylfluorene, spirofluorene, dibenzothiophene, or furan. In an exemplary implementation, a thickness of the hole transport layer may be about 40 nm to 150 nm.

In an exemplary implementation, the hole block layer and the electron transport layer may be made of aromatic heterocyclic compounds, such as benzimidazole derivatives, imidazopyridine derivatives, benzimidazophenanthridine derivatives, and other imidazole derivatives; pyrimidine derivatives, triazine derivatives, and other azine derivatives; quinoline derivatives, isoquinoline derivatives, phenanthroline derivatives, and other compounds containing a nitrogen-containing six-membered annular structure (also including compounds having a phosphine oxide-based substituent on a heterocyclic ring) . In an exemplary implementation, a thickness of the hole block layer may be about 5 nm to 15 nm, and a thickness of the electron transport layer may be about 20 nm to 50 nm.

In an exemplary implementation, an electron injection layer may be made of an alkali metal or a metal, such as lithium fluoride (LiF), ytterbium (Yb), magnesium (Mg), or Calcium (Ca), or a compound of these alkali metals or metals. In an exemplary implementation, a thickness of the electron injection layer may be about 0.5 nm to 2 nm.

(11) Forming a pattern of a cathode. In an exemplary implementation, forming the pattern of the cathode may include: evaporating a cathode material on the base substrate on which aforementioned patterns are formed to form a pattern of a cathode 94. The cathode 94 is connected to the organic light emitting layer 92, as shown in FIG. 26.

In an exemplary implementation, the cathode 94 may be in an integrated structure. In a region outside the auxiliary connection electrode, the cathode 94 is disposed on the organic light emitting layer 92. In a region where the auxiliary connection electrode is located, the cathode 94 is disposed on an exposed surface of the organic light emitting block on the one hand, and on an exposed surface of the auxiliary connection electrode on the other hand, thus forming a structure wrapping the auxiliary connection electrode and the organic light emitting block.

At this point, a pattern of a light emitting structure layer is manufactured on the drive circuit layer. The light emitting structure layer includes the anode, the auxiliary connection electrode, the pixel definition layer, the organic light emitting layer and the cathode. The organic light emitting layer is respectively connected to the anode and the cathode, the cathode is connected to the auxiliary connection electrode, and the auxiliary connection electrode is electrically connected to the second power supply line through the auxiliary cathode.

In an exemplary implementation, the manufacturing process of the display substrate may further include forming a pattern of an encapsulation layer, and forming the pattern of the encapsulation layer may include: firstly, using an open mask plate to deposit a first inorganic thin film by means of plasma enhanced chemical vapor deposition (PECVD) to form the first encapsulation layer. Then, ink-jet printing is performed on an organic material on the first encapsulation layer through an ink-jet printing process, and a second encapsulation layer is formed after curing, and then depositing a second inorganic thin film by using an open mask to form a third encapsulation layer, wherein the first encapsulation layer, the second encapsulation layer and the third encapsulation layer form the encapsulation layer. In an exemplary implementation, the first encapsulation layer and the third encapsulation layer may be made of any one or more of silicon oxide (SiOx), silicon nitride (SiNx), silicon carbide (SiC), silicon carbonitride (SiCN) and silicon nitride (SiON), and each may be in a single-layer structure, a multi-layer structure, or a composite layer structure. The second encapsulation layer may be made of a resin material, thereby forming a stacked structure of inorganic material/organic material/inorganic material, wherein the organic material layer is disposed between the two inorganic material layers, thus ensuring that the external moisture cannot enter the light emitting structure layer.

In an exemplary implementation, after the encapsulation layer is manufactured, a color film layer and a black matrix may be made on another substrate by a patterning process. A color film cover plate is formed, a frame sealing glue is coated on a surface of the color film cover plate, and the color film cover plate and the display substrate describe above are pressed together to form an OLED display panel as shown in FIG. 5. In FIG. 5, only the black matrix BM is shown, and the color film layer is not shown. The black matrix has multiple opening areas arranged in a matrix, and the color film layer is filled in the opening areas.

In some other exemplary embodiments, the color film layer and the black matrix may also be manufactured on the display substrate. At this point, the color film layer and the black matrix may be manufactured after the formation of the cathode and before the formation of the encapsulation layer. By providing the black matrix, optical crosstalk between adjacent sub-pixels can be effectively prevented, color mixing can be avoided, and the display effect can be improved.

Referring to FIGS. 5-26, in each sub-pixel, the first active layer 11, the first gate 12, the first source 13 and the first drain 14 constitute the first transistor T1. The second active layer 21, the second gate 22, the second source 23 and the second drain 24 constitute the second transistor T2. The third active layer 31, the third gate 32, the third source 33 and the third drain 34 constitute the third transistor T3. The first plate 41 and the second plate 42 constitute the first capacitor. The second plate 42 and the third plate 43 constitute the second capacitor. The first capacitor and the second capacitor are in a parallel structure, implementing storage of the potential of the second gate 22 of the sub-pixel in which the first capacitor and the second capacitor are located. The first transistors T1, the second transistors T2, the third transistors T3, the first capacitors and the second capacitors in the first sub-pixel P1 and the second sub-pixel P2 are mirror symmetric with respect to the compensation signal line S, and the first transistors T1, the second transistors T2, the third transistors T3, the first capacitors and the second capacitors in the third sub-pixel P3 and the fourth sub-pixel P4 are mirror symmetric with respect to the compensation signal line S.

In each sub-pixel, the first gate 12 is connected to the first scan signal line G1, the first source 13 is connected to the data signal line D, and the first drain 14 is connected to the second gate 22 of the sub-pixel where the first drain 14 is located. The second gate 22 is connected to the first drain 14 of the sub-pixel where the second gate 22 is located, the second source 23 is connected to the first power supply line VDD through the power connection line 52, and the second drain 24 is connected to the anode of the sub-pixel where the second drain 24 is located. The third gate 32 is connected to the second scan signal line G2, the third source 33 is connected to the compensation signal line S, and the third drain 34 is connected to the second drain 24 of the sub-pixel where the third drain 34 is located. The first plate 41 is connected to the second drain 24 and the third drain 34 of the sub-pixel where the first plate 41 is located, the second plate 42 is connected to the second gate 22 and the first drain 14 of the sub-pixel where the second plate 42 is located, and the third plate 43 is connected to the second drain 24 and the third drain 34 of the sub-pixel where the third plate 43 is located. The anode 74 is connected to the second drain 24 of the sub-pixel where the anode 74 is located, and the cathode 94 covering all sub-pixels is connected to the second power supply line VSS through the auxiliary connection electrode, so that the organic light emitting layer 92 between the anode 70 and the cathode 94 emits light with corresponding brightness in response to a current of the second drain 24 of the sub-pixel where the organic light emitting layer 92 is located.

In an exemplary implementation, the first conductive layer, the second conductive layer, and the third conductive layer may be made of a metal material, for example, any one or more of Argentum (Ag), Copper (Cu), Aluminum (Al), and Molybdenum (Mo), or an alloy material of the above-mentioned metals, for example, an Aluminum-Neodymium alloy (AINd) or a Molybdenum-Niobium alloy (MoNb), and may be in a single-layer structure, or in a multilayer composite structure such as Mo/Cu/Mo, etc. The first insulation layer, the second insulation layer, the third insulation layer, and the fourth insulation layer may be made of any one or more of silicon oxide (SiOx), silicon nitride (SiNx), and silicon oxynitride (SiON), and may be single-layer, multilayers, or composite layer. The first insulation layer is called a buffer layer, which is used for improving a capability of water and oxygen resistance of the base substrate, the second insulation layer is called a gate insulation (GI) layer, the third insulation layer is called an interlayer dielectric (ILD) layer, and the fourth insulation layer is called a passivation (PVX) layer. A thickness of the second insulation layer is smaller than a thickness of the third insulation layer, and a thickness of the first insulation layer is smaller than a sum of thicknesses of the second insulation layer and the third insulation layer, which increases the capacity of the storage capacitor, while ensuring the insulation effect. The planarization layer may be made of an organic material, the transparent conductive thin film may be made of indium tin oxide (ITO) or indium zinc oxide (IZO), and the pixel definition layer may be made of polyimide, acrylic or polyethylene terephthalate. The cathode may be made of any one or more of magnesium (Mg), silver (Ag), aluminum (Al), copper (Cu) and lithium (Li), or an alloy made of any one or more of the above metals.

In some possible implementations, the first insulation layer has a thickness of 3000 angstroms to 5000 angstroms, the second insulation layer has a thickness of 1000 angstroms to 2000 angstroms, the third insulation layer has a thickness of 4500 angstroms to 7000 angstroms, and the fourth insulation layer has a thickness of 3000 angstroms to 5000 angstroms. The first conductive layer has a thickness of 80 angstroms to 1200 angstroms, the second conductive layer has a thickness of 3000 angstroms to 5000 angstroms, and the third conductive layer has a thickness of 3000 angstroms to 9000 angstroms.

In an exemplary implementation, the semiconductor layer may be made of an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or multiple layers.

As shown in FIG. 5 to FIG. 26, a display substrate according to the present disclosure includes:
a base substrate 10;
a first conductive layer disposed on the base substrate 10, wherein the first conductive layer includes a first plate 41 and a compensation signal line S;
a third insulation layer 61 covering the first conductive layer;
a semiconductor layer disposed on the first insulation layer 61, wherein the semiconductor layer includes a first active layer 11, a second active layer 21 and a third active layer 31;
a second insulation layer 62 and a second conductive layer disposed on the second insulation layer 62, wherein the second conductive layer includes a first scan signal line G1, a second scan signal line G2, a second plate 42, a longitudinal power supply connection line 51, a transverse power supply connection line 52, an auxiliary power supply line 53, a first gate 12, a second gate 22, and a third gate 32, the second insulation layer 62 has a same pattern as the second conductive layer, there is an overlapped area between an orthographic projection of the second plate 42 on the base substrate 10 and an orthographic projection of the first plate 41 on the base substrate 10, and the second plate 42 and the first plate 41 form a first capacitance;
a third insulation layer 63 covering the second conductive layer and is provided with multiple vias;
a third conductive layer disposed on the third insulation layer 63, wherein the third conductive layer includes a first power supply line VDD, a second power supply line VSS, a data signal line D, a third scan connection line 53, a first source 13, a first drain 14, a second source 23, a second drain 24, a third source 33, a third drain 34 and a third plate 43, the first power supply line VDD is connected to the longitudinal power supply connection line 51 and the transverse power supply connection line 52 through eleventh vias V11, the second power supply line VSS is connected to the auxiliary power supply line 53 through the seventh via V7, the first source 13 and the data signal line D form an integrated structure, the second source 23 is connected to the second active layer 21 through the third via V3, the third source 33 is connected to the compensation signal line S through the eighth via V8, the first drain 14 is connected to the second gate 22 and the second plate 42 through ninth vias V9, the second drain 24, the third drain 34 and the third plate 43 are connected to each other to form an integrated structure, the third plate 43 is connected to the first plate 41 through the tenth via V10, there is an overlapped area between an orthographic projection of the third plate 43 on the base substrate 10 and an orthographic projection of the second plate 42 on the base substrate 10, and the second plate 42 and the third plate 43 form a second capacitor;
a fourth insulation layer 64 and a planarization layer 65 covering the third conductive layer and respectively provided with multiple vias;
an anode 74 and an auxiliary connection electrode disposed on the planarization layer 65, wherein the anode 74 includes a first anode 70, a second anode 71 and a third anode 72 that are stacked, and the auxiliary connection electrode includes a first connection electrode 81, a second connection electrode 82 and a third connection electrode 83 that are stacked, the first anode 70 is connected to the drain of the second transistor through the sixteenth via V16, and the first connection electrode 81 is connected to the second power supply line VSS through the seventeenth via V 17;
a pixel definition layer 91 disposed on the planarization layer 65, wherein the pixel definition layer 91 defines a first pixel opening exposing the anode in each sub-pixel, and the pixel definition layer 91 defines a second auxiliary electrode opening exposing the auxiliary connection electrode on the second power supply line VSS;
an organic light emitting layer 92 disposed in an area of the first pixel opening and an organic light emitting block disposed in an area of the second auxiliary electrode opening, wherein the organic light emitting layer 92 is connected to the anode, and the organic light emitting block is disposed to be isolated from the organic light emitting layer 92;
a cathode 94, wherein the cathode of the display area 100 is connected to the organic light emitting layer 92 and the cathode of the transparent area is connected to the second power supply line VSS through the auxiliary connection electrode; and
an encapsulation layer covering the above structures.

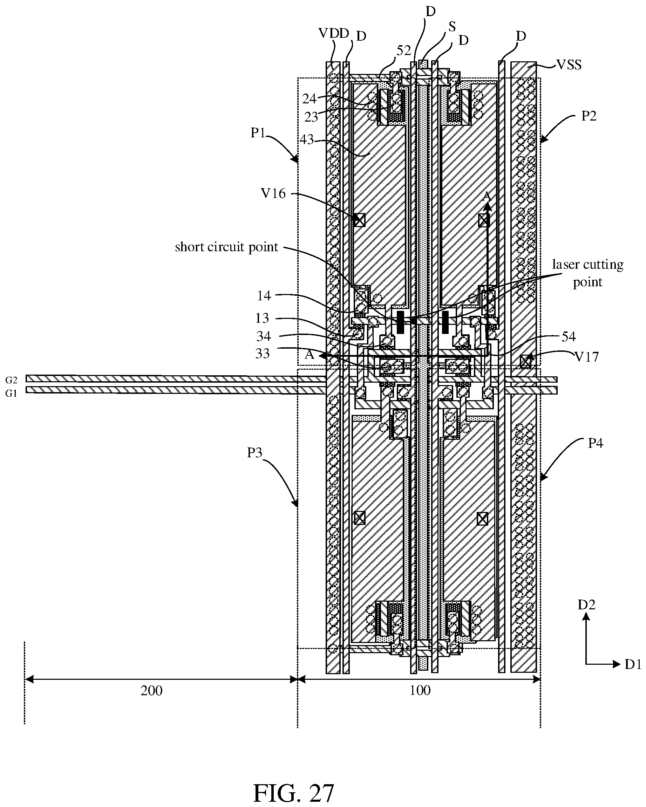

In the display substrate according to the embodiment of the present disclosure, when a short-circuit fault point occurs between the first scan connection line and/or the second scan connection line and other signal lines in the drive circuit layer, the first scan connection line and/or the second scan connection line on two sides of the short-circuit fault point can be cut off by laser cutting to repair the short-circuit fault. For example, as shown in FIG. 27, when a short-circuit fault point occurs at an overlapped position between the data signal line and the first scan connection line, the first scan connection line on two sides of the short-circuit fault point may be cut off by laser cutting to repair the short-circuit fault.

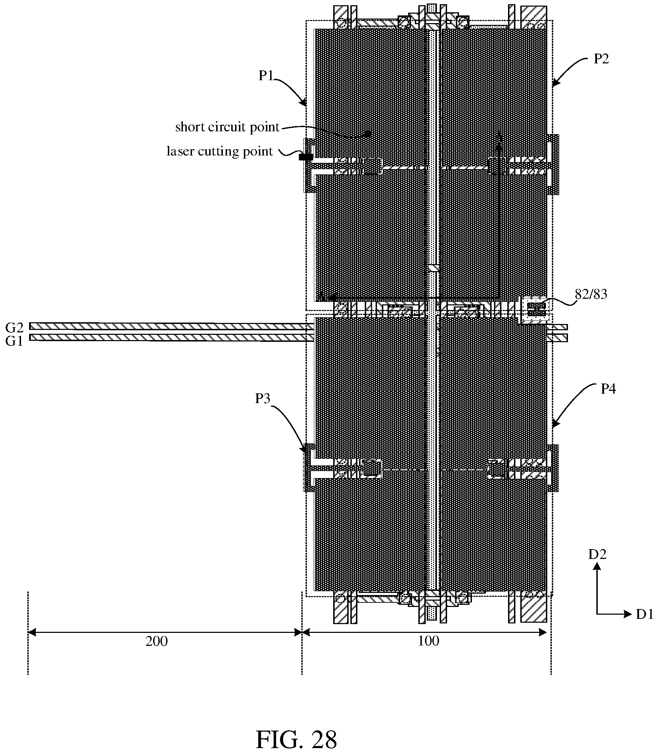

In a display substrate according to an embodiment of the present disclosure, as shown in FIG. 28, when a short circuit fault point occurs between a certain sub-anode block and another signal lines in the drive circuit layer, a position of the first connection electrode in the connection structure at one side of the sub-anode block can be cut by laser, whereby another sub-anode block in the sub-pixel corresponding to the sub-anode block can be electrically connected to the drive transistor, and the sub-anode block is floated to repair the short circuit fault.

The structure shown in the present disclosure and the manufacturing process thereof are merely an exemplary description. In an exemplary implementation, a corresponding structure may be altered and patterning processes may be increased or reduced according to actual needs. For example, the display area may include 3 sub-pixels. As another example, the pixel drive circuit may be 5T1C or 7T1C. As a further example, other electrodes or leads may further be provided in the film layer structure, which is not limited herein in the present disclosure.

As can be seen from the structure and manufacturing process of the display substrate described above, in the display substrate according to the embodiment of the present disclosure, the first scan signal line and the second scan signal line are designed to be respectively annularly wound with corresponding scan connection lines in the display area, and the annular wound positions of the first scan signal line and the second scan signal line are kept away from the first power supply line and the second power supply line. Therefore, a problem that a relatively large overlapped area of power supply lines and other signal lines leads to impact on the product yield is avoided. Under a functional condition where maintenance is available, the cross points between signal lines can be optimized to the minimum, thereby improving the product yield and providing technical support for transparent display of products.

In the display substrate according to the present disclosure, by using the second plate of metal oxide material as a plate of the storage capacitor, the second plate forms storage capacitors with the first plate in the first conductive layer and the third plate in the third conductive layer, respectively. The first plate and the third plate have a same potential, and the second plate has a potential different from that of the first plate and the third plate, so that two parallel storage capacitors are formed among the first plate, the second plate and the third plate, which effectively increases the capacity of the storage capacitors and is beneficial to realizing high-resolution display.

The manufacturing process according to the present disclosure may be implemented using the existing mature manufacturing equipment, and improvements to the existing process are small, such that it may be well compatible with the existing manufacturing process, be simple to implement, and be easy to practice, thereby achieving high production efficiency, low production cost and high yield rate. Internal repair of sub-pixel can be carried out through the design of the present disclosure, and the product yield is increased by more than twice.

In an exemplary implementation, the display substrate of the present disclosure may be applied to a display device with a pixel drive circuit, such as an OLED, a quantum dot display (QLED), a light emitting diode display (Micro LED or Mini LED) or a quantum dot light emitting diode display (QDLED), etc., which is not limited here in the present disclosure.

## Claims

1. A display substrate, comprising a base substrate (10) and a plurality of display units disposed on the base substrate (10), wherein each display unit comprises a display area (100) and a transparent area (200), the display area (100) comprises a plurality of sub-pixels;
the display area (100) is provided with a first power supply line (VDD) and a second power supply line (VSS) along a first direction; the first power supply line (VDD) and the second power supply line (VSS) extend along a second direction; the display area (100) is provided with a first scan signal line (G1), a second scan signal line (G2), a second scan connection line (G2-1) and a first scan connection line (G1-1) along the second direction; the second scan connection line (G2-1) and the second scan signal line (G2) are connected to each other to form a first annular structure; the display area (100) is provided with a third scan connection line (54) between the first scan signal line (G1) and the first scan connection line (G1-1); the third scan connection line (54), the first scan connection line (G1-1) and the first scan signal line (G1) are connected to each other to form a second annular structure, and the first direction (D1) intersects with the second direction (D2);
wherein an orthographic projection of the first annular structure on the base substrate (10) is not overlapped with an orthographic projection of the first power supply line (VDD) and the second power supply line (VSS) on the base substrate (10); an orthographic projection of the second annular structure on the base substrate (10) is not overlapped with the orthographic projection of the first power supply line (VDD) and the second power supply line (VSS) on the base substrate (10); and
wherein the orthographic projection of the first annular structure on the base substrate (10) is not overlapped with the orthographic projection of the second annular structure on the base substrate (10), and the orthographic projection of the second annular structure on the base substrate (10) wraps the orthographic projection of the first annular structure on the base substrate (10).

2. The display substrate according to claim 1, wherein in a direction perpendicular to the display substrate, a sub-pixel comprises a drive circuit layer (102) disposed on the base substrate (10) and a light emitting structure layer disposed at a side of the drive circuit layer (102) away from the base substrate (10), the drive circuit layer (102) comprises a first conductive layer, a semiconductor layer, a second conductive layer, and a third conductive layer;
the first conductive layer comprises a compensation signal line (S) and a first plate (41), the semiconductor layer comprises active layers of a plurality of transistors, the second conductive layer comprises the first scan signal line (G1), the second scan signal line (G2), the first scan connection line (G1-1), the second scan connection line (G2-1), a second plate (42) and gates of the plurality of transistors, the third conductive layer comprises the first power supply line (VDD), the second power supply line (VSS), the third scan connection line (54), a data signal line (D), and sources and drains of the plurality of transistors, and there is an overlapped area between an orthographic projection of the second plate (42) on the base substrate (10) and an orthographic projection of the first plate (41) on the base substrate (10), so that a first capacitance is formed;
the second scan connection line (G2-1) and the second scan signal line (G2) are connected to each other to form an integrated structure; and
the third scan connection line (54) is electrically connected to the first scan connection line (G1-1) and the first scan signal line (G1) through vias respectively.

3. The display substrate according to claim 1, wherein at least one of the sub-pixels comprises a first transistor (T1), a second transistor (T2), a third transistor (T3) and a first capacitor, the first capacitor comprises a first plate (41) and a second plate (42),
wherein a gate of the first transistor (T1) is electrically connected to the first scan signal line (G1), a first electrode of the first transistor (T1) is electrically connected to the data signal line (D), a second electrode of the first transistor (T1) is electrically connected to a gate of the second transistor, a first electrode of the second transistor (T2) is electrically connected to the first power supply line (VDD), a second electrode of the second transistor (T2) is electrically connected to a first electrode of an organic light emitting diode, a gate of the third transistor (T3) is electrically connected to the second scan signal line (G2), a first electrode of the third transistor (T3) is electrically connected to the compensation signal line (S), a second electrode of the third transistor (T3) is electrically connected to the second electrode of the second transistor (T2), a second electrode of the organic light emitting diode is electrically connected to the second power supply line (VSS), the first plate (41) is electrically connected to the second electrode of the second transistor (T2), and the second plate (42) is electrically connected to the gate of the second transistor (T2).

4. The display substrate according to claim 1, wherein the plurality of sub-pixels comprises a first sub-pixel (P1), a second sub-pixel (P2), a third sub-pixel (P3), and a fourth sub-pixel (P4), in the first direction (D1), the first sub-pixel (P1) and the second sub-pixel (P2) are alternately arranged to form a first row, the third sub-pixel (P3) and the fourth sub-pixel (P4) are alternately arranged to form a second row; and
the first scan connection line (G1-1) and the second scan connection line (G2-1) are located in the first sub-pixel (P1) and the second sub-pixel (P2) respectively, and the first scan signal line (G1) and the second scan signal line (G2) are located in the third sub-pixel (P3) and the fourth sub-pixel (P4) respectively.

5. The display substrate according to claim 4, wherein at least one of the sub-pixels comprises a first transistor (T1), a second transistor (T2) and a third transistor (T3), the first transistor (T1) comprises a first active layer, a first gate, a first source, and a first drain, the second transistor (T2) comprises a second active layer, a second gate, a second source, and a second drain, and the third transistor (T3) comprises a third active layer, a third gate, a third source, and a third drain,
wherein an area where the second scan signal line (G2) is overlapped with the third active layers in the third sub-pixel (P3) and the fourth sub-pixel (P4) serves as third gates in the third sub-pixel (P3) and the fourth sub-pixel (P4); an area where the second scan connection line (G2-1) is overlapped with the third active layers in the first sub-pixel (P1) and the second sub-pixel (P2) serves as third gates in the first sub-pixel (P1) and the second sub-pixel (P2); and
an area where the first scan signal line (G1) is overlapped with the first active layers in the third sub-pixel (P3) and the fourth sub-pixel (P4) serves as first gates in the third sub-pixel (P3) and the fourth sub-pixel (P4); an area where the first scan connection line (G1-1) is overlapped with the first active layers in the first sub-pixel (P1) and the second sub-pixel (P2) serves as first gates in the first sub-pixel (P1) and the second sub-pixel (P2).

6. The display substrate according to claim 5, wherein at least one of the display areas (100) further comprises a compensation signal line (S) extending in the second direction (D2);
the first gates, the second gates and the third gates in the first sub-pixel (P1) and the second sub-pixel (P2) are mirror-symmetrical with respect to a vertical axis, the first gates, the second gates and the third gates in the third sub-pixel (P3) and the fourth sub-pixel (P4) are mirror-symmetrical with respect to the vertical axis, wherein the vertical axis is the compensation signal line (S).

7. The display substrate according to claim 6, wherein the compensation signal line (S) is provided with a compensation connection line (S-1) protruding in the first direction (D1) and in an opposite direction of the first direction (D1);
the compensation connection line (S-1) is located at an abutment position of the first sub-pixel (P1) and the third sub-pixel (P3) and an abutment position of the second sub-pixel (P2) and the fourth sub-pixel (P4); and
the compensation connection line (S-1) is electrically connected to the third source of the third transistor (T3) through a via.

8. The display substrate according to claim 7, wherein the third active layers in the first sub-pixel (P1) to the fourth sub-pixel (P4) are each disposed at a position close to the compensation connection line (S-1), and there is an overlapped area between an orthographic projection of the third active layers on the base substrate (10) and an orthographic projection of the compensation connection line (S-1) on the base substrate (10).

9. The display substrate according to claim 7, wherein the third active layer in the first sub-pixel (P1) and the third active layer in the third sub-pixel (P3) are connected to each other to form an integrated structure, and the third active layer in the second sub-pixel (P2) and the third active layer in the fourth sub-pixel (P4) are connected to each other to form an integrated structure.

10. The display substrate according to claim 5, wherein at least one of the sub-pixels further comprises a first capacitor, the first capacitor comprises a first plate (41) and a second plate (42) disposed oppositely, and the second gate is disposed across the second active layer and connected to the second plate (42) to form an integrated structure.

11. The display substrate according to claim 10, wherein the first plate (41) in the first sub-pixel (P1) is provided with a first opening at a side close to the third sub-pixel (P3) and away from the second sub-pixel (P2); the first plate (41) in the second sub-pixel (P2) is further provided with the first opening at a side close to the fourth sub-pixel (P4) and away from the first sub-pixel (P1);
the first plate (41) in the third sub-pixel (P3) is provided with a second opening at a side close to the first sub-pixel (P1) and close to the fourth sub-pixel (P4); the first plate (41) in the fourth sub-pixel is further provided with the second opening at a side close to the second sub-pixel (P2) and close to the third sub-pixel (P3); and
the first active layers in the first sub-pixel (P1) and the second sub-pixel (P2) are each disposed at a position close to the respective first opening, and the first active layers in the third and fourth sub-pixels (P3, P4) are each disposed at a position close to the respective second opening.

12. The display substrate according to claim 10, wherein at least one of the sub-pixels further comprises a second capacitor, the second capacitor comprises a second plate (42) and a third plate (43) oppositely disposed, there is an overlapped area between an orthographic projection of the third plate (43) on the base substrate (10) and an orthographic projection of the second plate (42) on the base substrate (10), and the third plate (43) is electrically connected to the first plate (41) through a via.

13. A display device, including the display substrate of any one of claims 1 to 12.

14. A method for manufacturing a display substrate, comprising:
forming a plurality of display units on a base substrate (10), wherein each display unit comprises a display area (100) and a transparent area (200), the display area (100) is provided with a first power supply line (VDD) and a second power supply line (VSS) along a first direction (D1), the first power supply line (VDD) and the second power supply line (VSS) extend along a second direction (D2), the display area (100) is provided with a first scan signal line (G1), a second scan signal line (G2), a second scan connection line (G2-1) and a first scan connection line (G1-1) along the second direction (D2), the second scan connection line (G2-1) and the second scan signal line (G2) are connected to each other to form a first annular structure, the display area (100) is provided with a third scan connection line (54) between the first scan signal line (G1) and the first scan connection line (G1-1), the third scan connection line (54), the first scan connection line (G1-1) and the first scan signal line (G1) are connected to each other to form a second annular structure, the first direction (D1) intersects with the second direction (D2);
wherein an orthographic projection of the first annular structure on the base substrate (10) is not overlapped with an orthographic projection of the first power supply line (VDD) and the second power supply line (VSS) on the base substrate (10); an orthographic projection of the second annular structure on the base substrate (10) is not overlapped with the orthographic projection of the first power supply line (VDD) and the second power supply line (VSS) on the base substrate (10), and
wherein the orthographic projection of the first annular structure on the base substrate (10) is not overlapped with the orthographic projection of the second annular structure on the base substrate (10), and the orthographic projection of the second annular structure on the base substrate (10) wraps the orthographic projection of the first annular structure on the base substrate (10).

## Patentansprüche

1. Anzeigesubstrat, umfassend ein Grundsubstrat (10) und eine Vielzahl von Anzeigeeinheiten, welche auf dem Grundsubstrat (10) angeordnet sind, wobei jede Anzeigeeinheit eine Anzeigefläche (100) und eine durchsichtige Fläche (200) umfasst, wobei die Anzeigefläche (100) eine Vielzahl von Subpixeln umfasst;
wobei die Anzeigefläche (100) mit einer ersten Stromversorgungsleitung (VDD) und einer zweiten Stromversorgungsleitung (VSS) entlang einer ersten Richtung versehen ist; wobei sich die erste Stromversorgungsleitung (VDD) und die zweite Stromversorgungsleitung (VSS) entlang einer zweiten Richtung erstrecken; wobei die Anzeigefläche (100) mit einer ersten Abtastsignalleitung (G1), einer zweiten Abtastsignalleitung (G2), einer zweiten Abtastverbindungsleitung (G2-1) und einer ersten Abtastverbindungsleitung (G1-1) entlang der zweiten Richtung versehen ist; wobei die zweite Abtastverbindungsleitung (G2-1) und die zweite Abtastsignalleitung (G2) aneinander angeschlossen sind, um eine erste ringförmige Struktur zu bilden; wobei die Anzeigefläche (100) mit einer dritten Abtastverbindungsleitung (54) zwischen der ersten Abtastsignalleitung (G1) und der ersten Abtastverbindungsleitung (G1-1) versehen ist; wobei die dritte Abtastverbindungsleitung (54), die erste Abtastverbindungsleitung (G1-1) und die erste Abtastsignalleitung (G1) aneinander angeschlossen sind, um eine zweite ringförmige Struktur zu bilden, und die erste Richtung (D1) die zweite Richtung (D2) kreuzt;
wobei sich eine orthographische Projektion der ersten ringförmigen Struktur auf dem Grundsubstrat (10) nicht mit einer orthographischen Projektion der ersten Stromversorgungsleitung (VDD) und der zweiten Stromversorgungsleitung (VSS) auf dem Grundsubstrat (10) überlappt; wobei sich eine orthographische Projektion der zweiten ringförmigen Struktur auf dem Grundsubstrat (10) nicht mit der orthographischen Projektion der ersten Stromversorgungsleitung (VDD) und der zweiten Stromversorgungsleitung (VSS) auf dem Grundsubstrat (10) überlappt; und
wobei sich die orthographische Projektion der ersten ringförmigen Struktur auf dem Grundsubstrat (10) nicht mit der orthographischen Projektion der zweiten ringförmigen Struktur auf dem Grundsubstrat (10) überlappt, und die orthographische Projektion der zweiten ringförmigen Struktur auf dem Grundsubstrat (10) die orthographische Projektion der ersten ringförmigen Struktur auf dem Grundsubstrat (10) umhüllt.

2. Anzeigesubstrat nach Anspruch 1, wobei in einer Richtung senkrecht zum Anzeigesubstrat, ein Subpixel eine Treiberschaltungsschicht (102), welche auf dem Grundsubstrat (10) angeordnet ist, und eine lichtemittierende Strukturschicht, welche auf einer Seite der Treiberschaltungsschicht (102) entfernt vom Grundsubstrat (10) angeordnet ist, umfasst, wobei die Treiberschaltungsschicht (102) eine erste leitfähige Schicht, eine Halbleiterschicht, eine zweite leitfähige Schicht und eine dritte leitfähige Schicht umfasst;
wobei die erste leitfähige Schicht eine Kompensationssignalleitung (S) und eine erste Platte (41) umfasst, die Halbleiterschicht Aktivschichten einer Vielzahl von Transistoren umfasst, die zweite leitfähige Schicht die erste Abtastsignalleitung (G1), die zweite Abtastsignalleitung (G2), die erste Abtastverbindungsleitung (G1-1), die zweite Abtastverbindungsleitung (G2-1), eine zweite Platte (42) und Gates der Vielzahl von Transistoren umfasst, die dritte leitfähige Schicht die erste Stromversorgungsleitung (VDD), die zweite Stromversorgungsleitung (VSS), die dritte Abtastverbindungsleitung (54), eine Datensignalleitung (D), und Sourcen und Drains der Vielzahl von Transistoren umfasst, und es eine überlappte Fläche zwischen einer orthographischen Projektion der zweiten Platte (42) auf dem Grundsubstrat (10) und einer orthographischen Projektion der ersten Platte (41) auf dem Grundsubstrat (10) gibt, sodass eine erste Kapazität gebildet wird;
wobei die zweite Abtastverbindungsleitung (G2-1) und die zweite Abtastsignalleitung (G2) aneinander angeschlossen sind, um eine integrierte Struktur zu bilden; und
wobei die dritte Abtastverbindungsleitung (54) an der ersten Abtastverbindungsleitung (G1-1) und der ersten Abtastsignalleitung (G1) jeweils über Durchgänge elektrisch angeschlossen ist.

3. Anzeigesubstrat nach Anspruch 1, wobei mindestens eins der Subpixel einen ersten Transistor (T1), einen zweiten Transistor (T2), einen dritten Transistor (T3) und einen ersten Kondensator umfasst, wobei der erste Kondensator eine erste Platte (41) und eine zweite Platte (42) umfasst,
wobei ein Gate des ersten Transistors (T1) an der ersten Abtastsignalleitung (G1) elektrisch angeschlossen ist, eine erste Elektrode des ersten Transistors (T1) an der Datensignalleitung (D) elektrisch angeschlossen ist, eine zweite Elektrode des ersten Transistors (T1) am Gate des zweiten Transistors (T2) elektrisch angeschlossen ist, eine erste Elektrode des zweiten Transistors (T2) an der ersten Stromversorgungsleitung (VDD) elektrisch angeschlossen ist, eine zweite Elektrode des zweiten Transistors (T2) an einer ersten Elektrode einer organischen lichtemittierenden Diode elektrisch angeschlossen ist, ein Gate des dritten Transistors (T3) an der zweiten Abtastsignalleitung (G2) elektrisch angeschlossen ist, eine erste Elektrode des dritten Transistors (T3) an der Kompensationssignalleitung (S) elektrisch angeschlossen ist, eine zweite Elektrode des dritten Transistors (T3) an der zweiten Elektrode des zweiten Transistors (T2) elektrisch angeschlossen ist, eine zweite Elektrode der organischen lichtemittierenden Diode an der zweiten Stromversorgungsleitung (VSS) elektrisch angeschlossen ist, die erste Platte (41) an der zweiten Elektrode des zweiten Transistors (T2) angeschlossen ist und die zweite Platte (42) am Gate des zweiten Transistors (T2) elektrisch angeschlossen ist.

4. Anzeigesubstrat nach Anspruch 1, wobei die Vielzahl von Subpixeln ein erstes Subpixel (P1), ein zweites Subpixel (P2), ein drittes Subpixel (P3) und ein viertes Subpixel (P4), in der ersten Richtung (D1), umfasst, wobei das erste Subpixel (P1) und das zweite Subpixel (P2) abwechselnd angeordnet sind, um eine erste Zeile zu bilden, wobei das dritte Subpixel (P3) und das vierte Subpixel (P4) abwechselnd angeordnet sind, um eine zweite Zeile zu bilden; und
wobei sich die erste Abtastverbindungsleitung (G1-1) und die zweite Abtastverbindungsleitung (G2-1) jeweils im ersten Subpixel (P1) und im zweiten Subpixel (P2) befinden, und wobei sich die erste Abtastsignalleitung (G1) und die zweite Abtastsignalleitung (G2) jeweils im dritten Subpixel (P3) und im vierten Subpixel (P4) befinden.

5. Anzeigesubstrat nach Anspruch 4, wobei mindestens eins der Subpixel einen ersten Transistor (T1), einen zweiten Transistor (T2) und einen dritten Transistor (T3) umfasst, wobei der erste Transistor (T1) eine erste Aktivschicht, ein erstes Gate, eine erste Source und einen ersten Drain umfasst, wobei der zweite Transistor (T2) eine zweite Aktivschicht, ein zweites Gate, eine zweite Source und einen zweiten Drain umfasst, und wobei der dritte Transistor (T3) eine dritte Aktivschicht, ein drittes Gate, eine dritte Source und einen dritten Drain umfasst,
wobei eine Fläche, in welcher sich die zweite Abtastsignalleitung (G2) mit den dritten Aktivschichten im dritten Subpixel (P3) und im vierten Subpixel (P4) überlappt, als dritte Gates im dritten Subpixel (P3) und im vierten Subpixel (P4) dient; wobei eine Fläche, in welcher sich die zweite Abtastverbindungsleitung (G2-1) mit den dritten Aktivschichten im ersten Subpixel (P1) und im zweiten Subpixel (P2) überlappt, als dritte Gates im ersten Subpixel (P1) und im zweiten Subpixel (P2) dient; und
wobei eine Fläche, in welcher sich die erste Abtastsignalleitung (G1) mit den ersten Aktivschichten im dritten Subpixel (P3) und im vierten Subpixel (P4) überlappt, als erste Gates im dritten Subpixel (P3) und im vierten Subpixel (P4) dient; wobei eine Fläche, in welcher sich die erste Abtastverbindungsleitung (G1-1) mit den ersten Aktivschichten im ersten Subpixel (P1) und im zweiten Subpixel (P2) überlappt, als erste Gates im ersten Subpixel (P1) und im zweiten Subpixel (P2) dient.

6. Anzeigesubstrat nach Anspruch 5, wobei mindestens eine der Anzeigeflächen (100) zusätzlich eine Kompensationssignalleitung (S) umfasst, welche sich in der zweiten Richtung (D2) erstreckt;
wobei die ersten Gates, die zweiten Gates und die dritten Gates im ersten Subpixel (P1) und im zweiten Subpixel (P2) spiegelsymmetrisch in Bezug auf eine Vertikalachse sind, wobei die ersten Gates, die zweiten Gates und die dritten Gates im dritten Subpixel (P3) und im vierten Subpixel (P4) spiegelsymmetrisch in Bezug auf die Vertikalachse sind, wobei die Vertikalachse die Kompensationssignalleitung (S) ist.

7. Anzeigesubstrat nach Anspruch 6, wobei die Kompensationssignalleitung (S) mit einer Kompensationsverbindungsleitung (S-1) versehen ist, welche in der ersten Richtung (D1) und in einer der ersten Richtung (D1) entgegengesetzten Richtung hervorsteht;
wobei sich die Kompensationsverbindungsleitung (S-1) an einer Anlagestellung des ersten Subpixels (P1) und des dritten Subpixels (P3) und einer Anlagestellung des zweiten Subpixels (P2) und des vierten Subpixels (P4) befindet; und
wobei die Kompensationsverbindungsleitung (S-1) an der dritten Source des dritten Transistors (T3) über einen Durchgang elektrisch angeschlossen ist.

8. Anzeigesubstrat nach Anspruch 7, wobei die dritten Aktivschichten im ersten Subpixel (P1) bis zum vierten Subpixel (P4) jeweils an einer Stellung nah an der Kompensationsverbindungsleitung (S-1) angeordnet sind, und es eine überlappte Fläche zwischen einer orthographischen Projektion der dritten Aktivschichten auf dem Grundsubstrat (10) und einer orthographischen Projektion der Kompensationsverbindungsleitung (S-1) auf dem Grundsubstrat (10) gibt.

9. Anzeigesubstrat nach Anspruch 7, wobei die dritte Aktivschicht im ersten Subpixel (P1) und die dritte Aktivschicht im dritten Subpixel (P3) aneinander angeschlossen sind, um eine integrierte Struktur zu bilden, und die dritte Aktivschicht im zweiten Subpixel (P2) und die dritte Aktivschicht im vierten Subpixel (P4) aneinander angeschlossen sind, um eine integrierte Struktur zu bilden.

10. Anzeigesubstrat nach Anspruch 5, wobei mindestens eins der Subpixel zusätzlich einen ersten Kondensator umfasst, wobei der erste Kondensator eine erste Platte (41) und eine zweite Platte (42), welche gegenüberliegend angeordnet sind, umfasst, und das zweite Gate quer durch die zweite Aktivschicht angeordnet ist und an der zweiten Platte (42) angeschlossen ist, um eine integrierte Struktur zu bilden.

11. Anzeigesubstrat nach Anspruch 10, wobei die erste Platte (41) im ersten Subpixel (P1) mit einer ersten Öffnung auf einer Seite nah am dritten Subpixel (P3) und entfernt vom zweiten Subpixel (P2) versehen ist; wobei die erste Platte (41) im zweiten Subpixel (P2) zusätzlich mit der ersten Öffnung auf einer Seite nah am vierten Subpixel (P4) und entfernt vom ersten Subpixel (P1) versehen ist;
wobei die erste Platte (41) im dritten Subpixel (P3) mit einer zweiten Öffnung auf einer Seite nah am ersten Subpixel (P1) und nah am vierten Subpixel (P4) versehen ist; wobei die erste Platte (41) im vierten Subpixel zusätzlich mit der zweiten Öffnung auf einer Seite nah am zweiten Subpixel (P2) und nah am dritten Subpixel (P3) versehen ist; und
wobei die ersten Aktivschichten im ersten Subpixel (P1) und im zweiten Subpixel (P2) jeweils an einer Stellung nah an der jeweiligen ersten Öffnung angeordnet sind, und die ersten Aktivschichten im dritten und vierten Subpixel (P3, P4) jeweils an einer Stellung nah an der jeweiligen zweiten Öffnung angeordnet sind.

12. Anzeigesubstrat nach Anspruch 10, wobei mindestens eins der Subpixel zusätzlich einen zweiten Kondensator umfasst, wobei der zweite Kondensator eine zweite Platte (42) und eine dritte Platte (43), welche gegenüberliegend angeordnet sind, umfasst, es eine überlappte Fläche zwischen einer orthographischen Projektion der dritten Platte (43) auf dem Grundsubstrat (10) und einer orthographischen Projektion der zweiten Platte (42) auf dem Grundsubstrat (10) gibt und die dritte Platte (43) an der ersten Platte (41) über einen Durchgang elektrisch angeschlossen ist.

13. Anzeigevorrichtung, beinhaltend das Anzeigesubstrat nach einem der Ansprüche 1 bis 12.

14. Verfahren zur Herstellung eines Anzeigesubstrats, umfassend:
das Bilden einer Vielzahl von Anzeigeeinheiten auf einem Grundsubstrat (10), wobei jede Anzeigeeinheit eine Anzeigefläche (100) und eine durchsichtige Fläche (200) umfasst, die Anzeigefläche (100) mit einer ersten Stromversorgungsleitung (VDD) und einer zweiten Stromversorgungsleitung (VSS) entlang einer ersten Richtung (D1) versehen ist, sich die erste Stromversorgungsleitung (VDD) und die zweite Stromversorgungsleitung (VSS) entlang einer zweiten Richtung (D2) erstrecken, die Anzeigefläche (100) mit einer ersten Abtastsignalleitung (G1), einer zweiten Abtastsignalleitung (G2), einer zweiten Abtastverbindungsleitung (G2-1) und einer ersten Abtastverbindungsleitung (G1-1) entlang der zweiten Richtung (D2) versehen ist, die zweite Abtastverbindungsleitung (G2-1) und die zweite Abtastsignalleitung (G2) aneinander angeschlossen sind, um eine erste ringförmige Struktur zu bilden, die Anzeigefläche (100) mit einer dritten Abtastverbindungsleitung (54) zwischen der ersten Abtastsignalleitung (G1) und der ersten Abtastverbindungsleitung (G1-1) versehen ist, die dritte Abtastverbindungsleitung (54), die erste Abtastverbindungsleitung (G1-1) und die erste Abtastsignalleitung (G1) aneinander angeschlossen sind, um eine zweite ringförmige Struktur zu bilden, wobei die erste Richtung (D1) die zweite Richtung (D2) kreuzt;
wobei sich eine orthographische Projektion der ersten ringförmigen Struktur auf dem Grundsubstrat (10) nicht mit einer orthographischen Projektion der ersten Stromversorgungsleitung (VDD) und der zweiten Stromversorgungsleitung (VSS) auf dem Grundsubstrat (10) überlappt; wobei sich eine orthographische Projektion der zweiten ringförmigen Struktur auf dem Grundsubstrat (10) nicht mit der orthographischen Projektion der ersten Stromversorgungsleitung (VDD) und der zweiten Stromversorgungsleitung (VSS) auf dem Grundsubstrat (10) überlappt, und
wobei sich die orthographische Projektion der ersten ringförmigen Struktur auf dem Grundsubstrat (10) nicht mit der orthographischen Projektion der zweiten ringförmigen Struktur auf dem Grundsubstrat (10) überlappt, und die orthographische Projektion der zweiten ringförmigen Struktur auf dem Grundsubstrat (10) die orthographische Projektion der ersten ringförmigen Struktur auf dem Grundsubstrat (10) umhüllt.

## Revendications

1. Substrat d'affichage, comprenant un substrat de base (10) et une pluralité d'unités d'affichage agencées sur le substrat de base (10), chaque unité d'affichage comprenant une région d'affichage (100) et une région transparente (200), la région d'affichage (100) comprenant une pluralité de sous-pixels ;
la région d'affichage (100) étant pourvue d'une première ligne d'alimentation électrique (VDD) et d'une deuxième ligne d'alimentation électrique (VSS) le long d'une première direction ; la première ligne d'alimentation électrique (VDD) et la deuxième ligne d'alimentation électrique (VSS) s'étendant le long d'une deuxième direction ; la région d'affichage (100) étant pourvue d'une première ligne de signal de scan (G1), d'une deuxième ligne de signal de scan (G2), d'une deuxième ligne de connexion de scan (G2-1) et d'une première ligne de connexion de scan (G1-1) le long de la deuxième direction ; la deuxième ligne de connexion de scan (G2-1) et la deuxième ligne de signal de scan (G2) étant connectées l'une à l'autre pour former une première structure annulaire ; la région d'affichage (100) étant pourvue d'une troisième ligne de connexion de scan (54) entre la première ligne de signal de scan (G1) et la première ligne de connexion de scan (G1-1) ; la troisième ligne de connexion de scan (54), la première ligne de connexion de scan (G1-1) et la première ligne de signal de scan (G1) étant connectées les unes aux autres pour former une deuxième structure annulaire, et la première direction (D1) coupant la deuxième direction (D2) ;
dans lequel une projection orthographique de la première structure annulaire sur le substrat de base (10) n'est pas chevauchée par une projection orthographique de la première ligne d'alimentation électrique (VDD) et de la deuxième ligne d'alimentation électrique (VSS) sur le substrat de base (10) ; une projection orthographique de la deuxième structure annulaire sur le substrat de base (10) n'est pas chevauchée avec la projection orthographique de la première ligne d'alimentation électrique (VDD) et la deuxième ligne d'alimentation électrique (VSS) sur le substrat de base (10) ; et
dans lequel la projection orthographique de la première structure annulaire sur le substrat de base (10) n'est pas chevauchée avec la projection orthographique de la deuxième structure annulaire sur le substrat de base (10), et la projection orthographique de la deuxième structure annulaire sur le substrat de base (10) enveloppe la projection orthographique de la première structure annulaire sur le substrat de base (10).

2. Substrat d'affichage, selon la revendication 1, dans lequel, dans une direction perpendiculaire au substrat d'affichage, un sous-pixel comprend une couche de circuit de commande (102) agencée sur le substrat de base (10) et une couche de structure électroluminescente agencée sur un côté de la couche de circuit de commande (102) à l'opposé du substrat de base (10), la couche de circuit de commande (102) comprenant une première couche conductrice, une couche semi-conductrice, une deuxième couche conductrice et une troisième couche conductrice ;
la première couche conductrice comprend une ligne de signal de compensation (S) et une première plaque (41), la couche semi-conductrice comprend des couches actives d'une pluralité de transistors, la deuxième couche conductrice comprend la première ligne de signal de scan (G1), la deuxième ligne de signal de scan (G2), la première ligne de connexion de scan (G1-1), la deuxième ligne de connexion de scan (G2-1), une deuxième plaque (42) et des portes de la pluralité de transistors, la troisième couche conductrice comprend la première ligne d'alimentation (VDD), la deuxième ligne d'alimentation (VSS), la troisième ligne de connexion de scan (54), une ligne de signal de données (D), et des sources et des drains de la pluralité de transistors, et il existe une région de chevauchement entre une projection orthographique de la deuxième plaque (42) sur le substrat de base (10) et une projection orthographique de la première plaque (41) sur le substrat de base (10), de sorte qu'un premier condensateur est formé ;
la deuxième ligne de connexion de scan (G2-1) et la deuxième ligne de signal de scan (G2) sont connectées l'une à l'autre pour former une structure intégrée ;
et la troisième ligne de connexion de scan (54) est connectée électriquement à la première ligne de connexion de scan (G1-1) et à la première ligne de signal de scan (G1) par des vias respectivement.

3. Substrat d'affichage, selon la revendication 1, dans lequel au moins l'un des sous-pixels comprend un premier transistor (T1), un deuxième transistor (T2), un troisième transistor (T3) et un premier condensateur, le premier condensateur comprenant une première plaque (41) et une deuxième plaque (42),
dans lequel une porte du premier transistor (T1) est connectée électriquement à la première ligne de signal de scan (G1), une première électrode du premier transistor (T1) est connectée électriquement à la ligne de signal de données (D), une deuxième électrode du premier transistor (T1) est connectée électriquement à une porte du deuxième transistor, une première électrode du deuxième transistor (T2) est connectée électriquement à la première ligne d'alimentation (VDD), une deuxième électrode du deuxième transistor (T2) est connectée électriquement à une première électrode d'une diode électroluminescente organique, une porte du troisième transistor (T3) est connectée électriquement à la deuxième ligne de signal de scan (G2), une première électrode du troisième transistor (T3) est connectée électriquement à la ligne de signal de compensation (S), une deuxième électrode du troisième transistor (T3) est connectée électriquement à la deuxième électrode du deuxième transistor (T2), une deuxième électrode de la diode électroluminescente organique est connectée électriquement à la deuxième ligne d'alimentation (VSS), la première plaque (41) est connectée électriquement à la deuxième électrode du deuxième transistor (T2), et la deuxième plaque (42) est connectée électriquement à la porte du deuxième transistor (T2).

4. Substrat d'affichage, selon la revendication 1, dans lequel la pluralité de sous-pixels comprennent un premier sous-pixel (P1), un deuxième sous-pixel (P2), un troisième sous-pixel (P3) et un quatrième sous-pixel (P4), dans la première direction (D1), le premier sous-pixel (P1) et le deuxième sous-pixel (P2) étant agencés en alternance pour former une première rangée, le troisième sous-pixel (P3) et le quatrième sous-pixel (P4) étant agencés en alternance pour former une deuxième rangée ; et
la première ligne de connexion de scan (G1-1) et la deuxième ligne de connexion de scan (G2-1) étant agencées dans le premier sous-pixel (P1) et le deuxième sous-pixel (P2) respectivement, et la première ligne de signal de scan (G1) et la deuxième ligne de signal de scan (G2) étant agencées dans le troisième sous-pixel (P3) et le quatrième sous-pixel (P4) respectivement.

5. Substrat d'affichage, selon la revendication 4, dans lequel au moins l'un des sous-pixels comprend un premier transistor (T1), un deuxième transistor (T2) et un troisième transistor (T3), le premier transistor (T1) comprenant une première couche active, une première porte, une première source et un premier drain, le deuxième transistor (T2) comprenant une deuxième couche active, une deuxième porte, une deuxième source et un deuxième drain, et le troisième transistor (T3) comprenant une troisième couche active, une troisième porte, une troisième source et un troisième drain,
dans lequel une région où la deuxième ligne de signal de scan (G2) est chevauchée avec les troisièmes couches actives dans le troisième sous-pixel (P3) et le quatrième sous-pixel (P4) sert de troisièmes portes dans le troisième sous-pixel (P3) et le quatrième sous-pixel (P4) ; une région où la deuxième ligne de connexion de scan (G2-1) est chevauchée avec les troisièmes couches actives dans le premier sous-pixel (P1) et le deuxième sous-pixel (P2) sert de troisièmes portes dans le premier sous-pixel (P1) et le deuxième sous-pixel (P2) ; et
une région où la première ligne de signal de scan (G1) est chevauchée avec les premières couches actives dans le troisième sous-pixel (P3) et le quatrième sous-pixel (P4) sert de premières portes dans le troisième sous-pixel (P3) et le quatrième sous-pixel (P4) ; une région où la première ligne de connexion de scan (G1-1) est chevauchée avec les premières couches actives dans le premier sous-pixel (P1) et le deuxième sous-pixel (P2) sert de premières portes dans le premier sous-pixel (P1) et le deuxième sous-pixel (P2).

6. Substrat d'affichage, selon la revendication 5, dans lequel au moins une des régions d'affichage (100) comprend en outre une ligne de signal de compensation (S) s'étendant dans la deuxième direction (D2) ;
les premières portes, les deuxièmes portes et les troisièmes portes dans le premier sous-pixel (P1) et le deuxième sous-pixel (P2) sont symétriques en miroir par rapport à un axe vertical, les premières portes, les deuxièmes portes et les troisièmes portes dans le troisième sous-pixel (P3) et le quatrième sous-pixel (P4) sont symétriques en miroir par rapport à l'axe vertical, l'axe vertical étant la ligne de signal de compensation (S).

7. Substrat d'affichage, selon la revendication 6, dans lequel la ligne de signal de compensation (S) est pourvue d'une ligne de connexion de compensation (S-1) faisant saillie dans la première direction (D1) et dans une direction opposée à la première direction (D1) ;
la ligne de connexion de compensation (S-1) est située au niveau d'une position de butée du premier sous-pixel (P1) et le troisième sous-pixel (P3) et une position de butée du deuxième sous-pixel (P2) et du quatrième sous-pixel (P4) ; et
la ligne de connexion de compensation (S-1) est connectée électriquement à la troisième source du troisième transistor (T3) par l'intermédiaire d'un via.

8. Substrat d'affichage, selon la revendication 7, dans lequel les troisièmes couches actives dans le premier sous-pixel (P1) au quatrième sous-pixel (P4) sont chacune agencées à une position proche de la ligne de connexion de compensation (S-1), et il existe une région de chevauchement entre une projection orthographique des troisièmes couches actives sur le substrat de base (10) et une projection orthographique de la ligne de connexion de compensation (S-1) sur le substrat de base (10).

9. Substrat d'affichage, selon la revendication 7, dans lequel la troisième couche active dans le premier sous-pixel (P1) et la troisième couche active dans le troisième sous-pixel (P3) sont connectées l'une à l'autre pour former une structure intégrée, et la troisième couche active dans le deuxième sous-pixel (P2) et la troisième couche active dans le quatrième sous-pixel (P4) sont connectées l'une à l'autre pour former une structure intégrée.

10. Substrat d'affichage, selon la revendication 5, dans lequel au moins l'un des sous-pixels comprend en outre un premier condensateur, le premier condensateur comprenant une première plaque (41) et une deuxième plaque (42) agencées à l'opposée l'une de l'autre, et la deuxième porte étant agencée à travers la deuxième couche active et connectée à la deuxième plaque (42) pour former une structure intégrée.

11. Substrat d'affichage, selon la revendication 10, dans lequel la première plaque (41) dans le premier sous-pixel (P1) est pourvue d'une première ouverture sur un côté proche du troisième sous-pixel (P3) et éloignée du deuxième sous-pixel (P2) ; la première plaque (41) dans le deuxième sous-pixel (P2) étant en outre pourvue de la première ouverture sur un côté proche du quatrième sous-pixel (P4) et éloignée du premier sous-pixel (P1) ;
la première plaque (41) dans le troisième sous-pixel (P3) est pourvue d'une deuxième ouverture sur un côté proche du premier sous-pixel (P1) et proche du quatrième sous-pixel (P4) ; la première plaque (41) dans le quatrième sous-pixel est en outre pourvue de la deuxième ouverture sur un côté proche du deuxième sous-pixel (P2) et proche du troisième sous-pixel (P3) ; et
les premières couches actives dans le premier sous-pixel (P1) et le deuxième sous-pixel (P2) sont chacune agencées à une position proche de la première ouverture respective, et les premières couches actives dans le troisième et quatrième sous-pixels (P3, P4) sont chacune agencées à une position proche de la deuxième ouverture respective.

12. Substrat d'affichage, selon la revendication 10, dans lequel au moins l'un des sous-pixels comprend en outre un deuxième condensateur, le deuxième condensateur comprenant une deuxième plaque (42) et une troisième plaque (43) agencées à l'opposée l'une de l'autre, il existe une région de chevauchement entre une projection orthographique de la troisième plaque (43) sur le substrat de base (10) et une projection orthographique de la deuxième plaque (42) sur le substrat de base (10), et la troisième plaque (43) est connectée électriquement à la première plaque (41) par l'intermédiaire d'un via.

13. Dispositif d'affichage, comprenant le substrat d'affichage selon l'une quelconque des revendications 1 à 12.

14. Procédé de fabrication d'un substrat d'affichage, comprenant :
la formation d'une pluralité d'unités d'affichage sur un substrat de base (10), chaque unité d'affichage comprenant une région d'affichage (100) et une région transparente (200), la région d'affichage (100) étant pourvue d'une première ligne d'alimentation électrique (VDD) et d'une deuxième ligne d'alimentation électrique (VSS) le long d'une première direction (D1), la première ligne d'alimentation électrique (VDD) et la deuxième ligne d'alimentation électrique (VSS) s'étendant le long d'une deuxième direction (D2), la région d'affichage (100) étant pourvue d'une première ligne de signal de scan (G1), d'une deuxième ligne de signal de scan (G2), d'une deuxième ligne de connexion de scan (G2-1) et d'une première ligne de connexion de scan (G1-1) le long de la deuxième direction (D2), la deuxième ligne de connexion de scan (G2-1) et la deuxième ligne de signal de scan (G2) étant connectées l'une à l'autre pour former une première structure annulaire, la région d'affichage (100) étant pourvue d'une troisième ligne de connexion de scan (54) entre la première ligne de signal de scan (G1) et la première ligne de connexion de scan (G1-1), la troisième ligne de connexion de scan (54), la première ligne de connexion de scan (G1-1) et la première ligne de signal de scan (G1) étant connectées les unes aux autres pour former une deuxième structure annulaire, la première direction (D1) coupant la deuxième direction (D2) ;
dans lequel une projection orthographique de la première structure annulaire sur le substrat de base (10) n'est pas chevauchée avec une projection orthographique de la première ligne d'alimentation électrique (VDD) et de la deuxième ligne d'alimentation électrique (VSS) sur le substrat de base (10) ; dans lequel une projection orthographique de la deuxième structure annulaire sur le substrat de base (10) n'est pas chevauchée avec la projection orthographique de la première ligne d'alimentation électrique (VDD) et de la deuxième ligne d'alimentation électrique (VSS) sur le substrat de base (10), et
dans lequel la projection orthographique de la première structure annulaire sur le substrat de base (10) n'est pas chevauchée avec la projection orthographique de la deuxième structure annulaire sur le substrat de base (10), et la projection orthographique de la deuxième structure annulaire sur le substrat de base (10) enveloppe la projection orthographique de la première structure annulaire sur le substrat de base (10).
